# EUROPEAN PATENT APPLICATION

(11) **EP 2 023 401 A1**
(43) Date of publication of application: **11.02.2009**
(21) Application number: 07741706.1
(22) Date of filing: 16.04.2007
(51) Int. Cl.: H01L 31/042, G01M 11/00, G01N 21/956

(54) **SOLAR BATTERY MODULE EVALUATION DEVICE, SOLAR BATTERY MODULE EVALUATING METHOD, AND SOLAR BATTERY MODULE MANUFACTURING METHOD**

(30) Priority: 28.04.2006 JP 2006126849; 31.05.2006 JP 2006152228
(71) Applicant: Sharp Kabushiki Kaisha, Osaka-shi, Osaka 545-8522 (JP)
(72) Inventor: HARADA, Takashi, Nara 639-2122 (JP); OHBASAMI, Masahiro, Nara 639-0252 (JP); UMETANI, Yoshinobu, Nara 635-0055 (JP); KATAYAMA, Yoshio, Hiroshima 739-0144 (JP); TANIGAMI, Takuji, Nara 634-0042 (JP)
(74) Representative: Müller - Hoffmann & Partner
(86) International application number: PCT/JP2007/058270
(87) International publication number: WO 2007/125778

(57) **Abstract**

Management of a manufacturing process also in assembling a solar battery module is facilitated. A solar battery module evaluation apparatus (10) includes a power supply unit (11), a camera (12), and a processing unit (13). The power supply unit (11) supplies electric power. The processing unit (13) outputs pattern information indicating whether a solar battery module (120) is defective or not, based on data of an image picked up by the camera (12), the image being an optical image that appears as a result of supply of electric power to the solar battery module (120) for light emission through electroluminescence phenomenon.

## Description

### TECHNICAL FIELD

The present invention relates to a solar battery module evaluation apparatus, a solar battery module evaluation method, and a solar battery module manufacturing method, and particularly to a solar battery module evaluation apparatus, a solar battery module evaluation method, and a solar battery module manufacturing method utilizing energy conversion.

### BACKGROUND ART

One method of utilizing clean energy is to use such a solar power generation system for residential application that a solar battery module is mounted on a roof of a house or the like. The solar battery module refers to an assembly obtained by electrically connecting a plurality of solar battery cells to each other. The solar power generation system for residential application has recently become widespread.

A solar battery module mounted on a roof of a house or the like is constituted of solar battery cells for converting light energy to electric energy, a frame portion holding the solar battery cells, and the like. The solar battery cells are formed, for example, as a superstrate structure. The superstrate structure refers to a structure in which a monocrystalline or polycrystalline solar battery cell is formed and enclosed with a resin between glass and a weather-resistant film in a sandwiched manner. The frame portion is formed of upper and lower, ridge-side frame and eave-side frame, a left-side frame, and a right-side frame. Such a frame portion surrounds a peripheral portion of the solar battery cell to hold the same.

A solar battery cell is an apparatus directly converting solar energy to electric energy. There are various types of solar battery cells, such as a solar battery cell including a compound semiconductor or a solar battery cell including an organic material. A solar battery cell including silicon crystal is currently mainstream. Particularly from the viewpoint of global environmental issues, in recent years, a solar battery cell has increasingly been expected to serve as a clean energy source.

As a background to widespread use of the solar power generation system for residential application, a solar battery cell of a mass-production type, that has achieved conversion efficiency exceeding approximately 17%, has been developed. Various types of characteristic evaluation, as a form of technical development for further improvement in conversion efficiency in the future, have been conducted.

For example, Non-Patent Document 1 (Yasue KAJI et al., "Characterization of Polycrystalline Silicon Solar Cells by Electroluminescence") discloses one method of evaluating characteristics of a silicon solar battery cell. This method attempts to detect photoluminescence (hereinafter referred to as "PL") and electroluminescence (hereinafter referred to as "EL") from the silicon solar battery cell and analyzes EL spectrum and EL intensity distribution, so that precise characteristic evaluation of the solar battery cell can be achieved.

Non-Patent Document 1: Yasue KAJI et al., 15th International Photovoltaic Science & Engineering Conference (PVSEC-15), "Characterization of Polycrystalline Silicon Solar Cells by Electroluminescence," 2005, pp. 153-154.

### DISCLOSURE OF THE INVENTION

### PROBLEMS TO BE SOLVED BY THE INVENTION

The invention disclosed in Non-Patent Document 1, however, suffers from difficulty in application thereof to inspection of a mass-production type solar battery cell.

This difficulty will specifically be described. In order to mount a solar power generation system on a roof, mass production of solar battery modules is required. In order to realize mass production of solar battery modules, a technique for mass-producing the solar battery modules of high yield, in which conversion efficiency of each solar battery cell is maintained, is required. In order to mass-produce the solar battery modules of high yield, in which conversion efficiency of each solar battery cell is maintained, it is necessary not only to manage a process of manufacturing solar battery cells but also to manage a manufacturing process in assembling a solar battery module. In order to manage the manufacturing process also in assembling the solar battery module, a method of inspecting the solar battery module such that a result of inspection of the solar battery module can immediately be fed back to the manufacturing process is required.

According to the conventional technique, however, such inspection that a cause of a defective product can immediately be specified has been difficult. In inspecting a solar battery module with the conventional technique, whether the module is defective or not can immediately be inspected, however, the cause thereof cannot be specified. Accordingly, it has been necessary to subsequently disassemble the solar battery module determined as defective and to specify the cause. With such a method, it is extremely difficult to immediately provide feedback of the result of inspection of the solar battery module to the manufacturing process. Non-Patent Document 1 describes the feature that the solar battery cell can emit light, for example, with a method of applying electric power to the solar battery module. Non-Patent Document 1, however, neither discloses nor suggests inspection of the solar battery module such that the cause of a defective product can be specified.

The present invention was made to solve the above-described problems, and an object of the present invention is to provide a solar battery module evaluation apparatus, a solar battery module evaluation method, and a solar battery module manufacturing method facilitating management of a manufacturing process also in assembling a solar battery module by inspecting the solar battery module to specify a cause of defect.

### MEANS FOR SOLVING THE PROBLEMS

In order to achieve the object above, according to one aspect of the present invention, an evaluation apparatus for evaluating a solar battery module is provided. The solar battery module includes a plurality of solar battery cells. The plurality of solar battery cells are connected to one another through an interconnector. The evaluation apparatus includes: a supply unit supplying energy to the solar battery module; an image pick-up unit outputting image data by picking up an optical image that appears as a result of supply of the energy; and an output unit for outputting pattern information indicating whether the solar battery module is defective or not, based on data of a first image corresponding to the optical image.

Preferably, the output unit includes a first storage unit storing in advance data of a second image which is an optical image that appears as a result of supply of the energy to a defective solar battery module, a comparison unit comparing the first image with the second image, and an information output unit outputting information on defect presented by the first image when it is determined that the first image and the second image exhibit a defective pattern of an identical type.

Preferably, the output unit outputs the pattern information based on the data of the first image for one solar battery string.

Preferably, the output unit outputs the pattern information based on the data of the first image for one solar battery cell.

Preferably, the output unit outputs the pattern information based on the data of the first image including shadow of an electrode of the solar battery cell.

Preferably, the output unit outputs the pattern information by using data of a portion on which shadow of the electrode is cast in the data of the first image.

Preferably, the evaluation apparatus further includes a first identification unit identifying a first identification code which is an identification code for the data of the first image, and a second storage unit storing the data of the first image and the first identification code in association with each other.

Preferably, the evaluation apparatus further includes a second identification unit identifying a second identification code which is an identification code of the solar battery module, and a third storage unit for storing the pattern information and the second identification code in association with each other.

Preferably, the supply unit supplies energy to the solar battery module of a flat panel type made of silicon.

The supply unit supplies electric power.

Preferably, the supply unit supplies the electric power for having each solar battery cell constituting the solar battery module emit light through electroluminescence phenomenon.

Preferably, the supply unit supplies energy to the solar battery cell through a lead connected to the interconnector.

Preferably, the supply unit supplies the energy through a plurality of leads to a solar battery string obtained by connecting the solar battery cells to one another in series through the interconnector.

Preferably, the supply unit includes a plurality of terminals in contact with a plurality of leads respectively, for supplying the energy, and a plurality of diodes connected between the plurality of terminals, respectively.

Preferably, the supply unit includes a plurality of terminals in contact with a plurality of leads respectively, and a setting unit for setting a voltage across at least two terminals among the plurality of terminals to a voltage adapted to combination of the terminals.

Preferably, the setting unit includes a plurality of diodes connected between the plurality of terminals respectively and sets a voltage across opposing ends of the plurality of diodes.

According to another aspect of the present invention, a method of evaluating a solar battery module is provided. The solar battery module includes a plurality of solar battery cells. The plurality of solar battery cells are connected to one another through an interconnector. The method includes the steps of: supplying energy to the solar battery module; outputting image data by picking up an optical image that appears as a result of supply of the energy; and outputting pattern information indicating whether the solar battery module is defective or not, based on data of a first image corresponding to the optical image.

Preferably, the step of supplying energy includes the step of supplying energy to the solar battery cell through a lead drawn from an enclosing material and connected to the interconnector, after the plurality of solar battery cells are laminated with the enclosing material and before the solar battery module is cured.

Preferably, the step of supplying energy to the solar battery cell includes the step of supplying the energy through the lead to each of a plurality of sets of the solar battery cells, in which the solar battery cells are connected to one another in series through the interconnector and sectioned by the lead.

According to another aspect of the present invention, a method of manufacturing a solar battery module is provided. The method includes: a first fabrication step of fabricating a solar battery string by connecting solar battery cells to one another in series through a conductive member; a second fabrication step of fabricating a solar battery cell array by connecting a plurality of the solar battery strings to one another in series through a conductive member; an enclosing step of enclosing the solar battery cell array with an enclosing material; a supply step of supplying energy to a solar battery module which is the solar battery cell array enclosed in the enclosing step; an image pick-up step of picking up an image of the solar battery module; a determination step of determining whether the solar battery module is defective or not based on data of a first image which is an image picked up in the image pick-up step, the image being an optical image that appears as a result of supply of the energy to the solar battery module; and a changing step of changing content in at least one step among the first fabrication step, the second fabrication step and the enclosing step, in accordance with a result of determination in the determination step.

A method of manufacturing a solar battery module according to another aspect of the present invention includes: a first fabrication step of fabricating a solar battery string by connecting solar battery cells to one another in series through a conductive member; a second fabrication step of fabricating a solar battery cell array by connecting a plurality of the solar battery strings to one another in series through a conductive member; a laminating step of laminating the solar battery cell array with an enclosing material; a supply step of supplying energy to the solar battery cell through a lead drawn from the enclosing material and connected to an interconnector; an image pick-up step of picking up an image of the solar battery module; a determination step of determining whether the solar battery module is defective or not based on data of a first image which is an image picked up in the image pick-up step, the image being an optical image that appears as a result of supply of the energy to the solar battery module; a curing step of curing the solar battery module when the solar battery module has been determined as non-defective in the determination step; and a connection step of connecting an electric power output terminal to the lead.

Preferably, the method of manufacturing a solar battery module further includes a replacement step of replacing the solar battery cell when the solar battery module has been determined as defective in the determination step.

Preferably, the method of manufacturing a solar battery module further includes a replacement step of replacing a part of the solar battery module on a basis of the solar battery string when the solar battery module has been determined as defective in the determination step.

Preferably, the laminating step includes the step of laminating the enclosing material with at least a sheet material and laminating the solar battery cell array. The method of manufacturing a solar battery module further includes a replacement step of replacing at least one of the solar battery cell and the solar battery string after at least a part of the sheet material is peeled off, when the solar battery module has been determined as defective in the determination step.

Preferably, the enclosing material is ethylene vinyl acetate.

### EFFECTS OF THE INVENTION

The solar battery module evaluation apparatus, the solar battery module evaluation method, and the solar battery module manufacturing method according to the present invention can facilitate management of the manufacturing process also in assembling a solar battery module by inspecting the solar battery module to specify a cause of defect.

### BRIEF DESCRIPTION OF THE DRAWINGS

Fig. 1 is a configuration diagram showing a solar battery module evaluation apparatus according to a first embodiment of the present invention.
Fig. 2 is a control block diagram of a processing unit according to the first embodiment of the present invention.
Fig. 3 is a control block diagram of computer hardware implementing the processing unit according to the first embodiment of the present invention.
Fig. 4 is a schematic cross-sectional view of a solar battery cell according to the first embodiment of the present invention.
Fig. 5 is a diagram showing a pattern of a bus bar electrode and a finger electrode according to the first embodiment of the present invention.
Fig. 6 is a diagram showing a pattern of an aluminum electrode and a silver electrode formed on a back surface of a p-type silicon substrate according to the first embodiment of the present invention.
Fig. 7 is a flowchart showing a procedure for manufacturing a solar battery module according to the first embodiment of the present invention.
Fig. 8 is a schematic cross-sectional view of a solar battery string according to the first embodiment of the present invention.
Fig. 9 is a plan view of a part of the solar battery string according to the first embodiment of the present invention, when viewed from a light-receiving surface side.
Fig. 10 is a plan view of a part of the solar battery string according to the first embodiment of the present invention, when viewed from a back surface side.
Fig. 11 is a diagram schematically showing arrangement of the solar battery strings and a connection state of wiring members in the solar battery module according to the first embodiment of the present invention.
Fig. 12 is a diagram illustrating a structure of the solar battery module according to the first embodiment of the present invention.
Fig. 13 is a cross-sectional view of the solar battery module according to the first embodiment of the present invention.
Fig. 14 is a diagram of the completed solar battery module according to the first embodiment of the present invention.
Fig. 15 is a diagram showing a bottom surface of the completed solar battery module according to the first embodiment of the present invention.
Fig. 16 is a diagram showing as a circuit diagram, arrangement of the solar battery cells and a connection state of a bypass diode in the solar battery module according to the first embodiment of the present invention.
Fig. 17 is a flowchart showing a procedure for controlling processing for inspecting the solar battery module according to the first embodiment of the present invention.
Fig. 18 is a diagram illustrating a first image when a defect is caused, according to the first embodiment of the present invention.
Fig. 19 is a diagram illustrating a second image when a defect is caused, according to the first embodiment of the present invention.
Fig. 20 is a diagram illustrating a third image when a defect is caused, according to the first embodiment of the present invention.
Fig. 21 is a diagram illustrating a fourth image when a defect is caused, according to the first embodiment of the present invention.
Fig. 22 is a diagram illustrating a fifth image when a defect is caused, according to the first embodiment of the present invention.
Fig. 23 is a diagram showing as a circuit diagram, generation of a current path via a bypass diode in the solar battery module according to the first embodiment of the present invention.
Fig. 24 is a diagram illustrating a state that the first image according to the first embodiment of the present invention has been subjected to processing for division into solar battery cells.
Fig. 25 is a diagram showing that a solar battery cell corresponding to a pattern mode "A1" corresponds to a defective mode "V".
Fig. 26 is a diagram illustrating a state that the second image according to the first embodiment of the present invention has been subjected to processing for division into solar battery cells.
Fig. 27 is a diagram showing that a solar battery cell corresponding to a pattern mode "A2" corresponds to a defective mode "W".
Fig. 28 is a diagram illustrating a state that the third image according to the first embodiment of the present invention has been subjected to processing for division into solar battery cells.
Fig. 29 is a diagram showing that a solar battery cell corresponding to a pattern mode "C" corresponds to a defective mode "X".
Fig. 30 is a diagram illustrating a state that the fourth image according to the first embodiment of the present invention has been subjected to processing for division into solar battery cells.
Fig. 31 is a diagram showing that a solar battery cell corresponding to a pattern mode "D" corresponds to a defective mode "Y".
Fig. 32 is a diagram illustrating a state that the fifth image according to the first embodiment of the present invention has been subjected to processing for division into solar battery cells.
Fig. 33 is a diagram showing that a solar battery cell corresponding to a pattern mode "D" corresponds to a defective mode "Z".
Fig. 34 is a configuration diagram showing a solar battery module evaluation apparatus according to a second embodiment of the present invention.
Fig. 35 is a control block diagram of a processing unit according to the second embodiment of the present invention.
Fig. 36 is a control block diagram of computer hardware implementing the processing unit according to the second embodiment of the present invention.
Fig. 37 is a schematic cross-sectional view of a solar battery cell according to the second embodiment of the present invention.
Fig. 38 is a diagram showing a pattern of a bus bar electrode and a finger electrode according to the second embodiment of the present invention.
Fig. 39 is a diagram showing a pattern of an aluminum electrode and a silver electrode formed on a back surface of a p-type silicon substrate according to the second embodiment of the present invention.
Fig. 40 is a flowchart showing a procedure for manufacturing a solar battery module according to the second embodiment of the present invention.
Fig. 41 is a schematic cross-sectional view of a solar battery string according to the second embodiment of the present invention.
Fig. 42 is a plan view of a part of the solar battery string according to the second embodiment of the present invention, when viewed from a light-receiving surface side.
Fig. 43 is a plan view of a part of the solar battery string according to the second embodiment of the present invention, when viewed from a back surface side.
Fig. 44 is a diagram schematically showing arrangement of the solar battery strings and a connection state of wiring members in a solar battery cell array according to the second embodiment of the present invention.
Fig. 45 is a diagram illustrating a structure of a solar battery module in process according to the second embodiment of the present invention.
Fig. 46 is a cross-sectional view of the solar battery module in process according to the second embodiment of the present invention.
Fig. 47 is a diagram illustrating wiring in a connector according to the second embodiment of the present invention.
Fig. 48 is a conceptual diagram illustrating a mechanical structure of the connector according to the second embodiment of the present invention.
Fig. 49 is a diagram illustrating a structure of the completed solar battery module according to the second embodiment of the present invention.
Fig. 50 is a cross-sectional view of the completed solar battery module according to the second embodiment of the present invention.
Fig. 51 is a diagram of the completed solar battery module according to the second embodiment of the present invention.
Fig. 52 is a diagram showing a bottom surface of the completed solar battery module according to the second embodiment of the present invention.
Fig. 53 is a diagram showing as a circuit diagram, arrangement of the solar battery cells and a connection state of a bypass diode in the completed solar battery module according to the second embodiment of the present invention.
Fig. 54 is a flowchart showing a procedure for controlling processing for inspecting the solar battery module according to the second embodiment of the present invention.
Fig. 55 is a diagram illustrating a first image when a defect is caused, according to the second embodiment of the present invention.
Fig. 56 is a diagram illustrating a second image when a defect is caused, according to the second embodiment of the present invention.
Fig. 57 is a diagram illustrating a third image when a defect is caused, according to the second embodiment of the present invention.
Fig. 58 is a diagram illustrating a fourth image when a defect is caused, according to the second embodiment of the present invention.
Fig. 59 is a diagram illustrating a fifth image when a defect is caused, according to the second embodiment of the present invention.
Fig. 60 is a diagram showing as a circuit diagram, generation of a current path via a bypass diode in the solar battery module in process according to the second embodiment of the present invention.
Fig. 61 is a diagram illustrating a state that the first image according to the second embodiment of the present invention has been subjected to processing for division into solar battery cells.
Fig. 62 is a diagram showing that a solar battery cell corresponding to pattern mode "A1" corresponds to defective mode "V".
Fig. 63 is a diagram illustrating a state that the second image according to the second embodiment of the present invention has been subjected to processing for division into solar battery cells.
Fig. 64 is a diagram showing that a solar battery cell corresponding to pattern mode "A2" corresponds to defective mode "W".
Fig. 65 is a diagram illustrating a state that the third image according to the second embodiment of the present invention has been subjected to processing for division into solar battery cells.
Fig. 66 is a diagram showing that a solar battery cell corresponding to pattern mode "C" corresponds to defective mode "X".
Fig. 67 is a diagram illustrating a state that the fourth image according to the second embodiment of the present invention has been subjected to processing for division into solar battery cells.
Fig. 68 is a diagram showing that a solar battery cell corresponding to pattern mode "D" corresponds to defective mode "Y".
Fig. 69 is a diagram illustrating a state that the fifth image according to the second embodiment of the present invention has been subjected to processing for division into solar battery cells.
Fig. 70 is a diagram showing that a solar battery cell corresponding to pattern mode "D" corresponds to defective mode "Z".
Fig. 71 is a diagram illustrating wiring in a connector according to an eighth variation of the second embodiment of the present invention.
Fig. 72 is a diagram illustrating wiring in a connector according to a ninth variation of the second embodiment of the present invention.

### DESCRIPTION OF THE REFERENCE SIGNS

10 solar battery module evaluation apparatus; 11 power supply unit; 12 camera; 13 processing unit; 14 power supply terminal; 15 control unit; 16 recognition unit; 17 pattern storage unit; 18 comparison unit; 19 evaluation unit; 20 result storage unit; 21 external memory; 100 solar battery cell; 101 p-type silicon substrate; 102 n+ layer; 103 anti-reflection coating; 104 bus bar electrode; 105 aluminum electrode; 106 p+ layer; 107 silver electrode; 108 finger electrode; 109 interconnector; 110 solar battery string; 111, 112, 113 wiring member; 120 solar battery module; 121 glass plate; 122, 124 EVA film; 123 solar battery cell array; 125 back film; 127 terminal box; 128 cable; 129 output terminal; 130 bypass diode; 500 CPU; 501 display; 502 keyboard; 503 speaker; 504 ROM; 505 RAM; 506 memory drive device; 507 mouse; 508 communication device; 509 interface; 600 PC card; 602 warning light; 1262, 1264 aluminum frame; 1292 female terminal; and 1294 male terminal.

### BEST MODES FOR CARRYING OUT THE INVENTION

An embodiment of the present invention will be described hereinafter with reference to the drawings. In the description below, the same elements have the same reference characters allotted. Their label and function are also identical. Therefore, detailed description thereof will not be repeated.

### <First Embodiment>

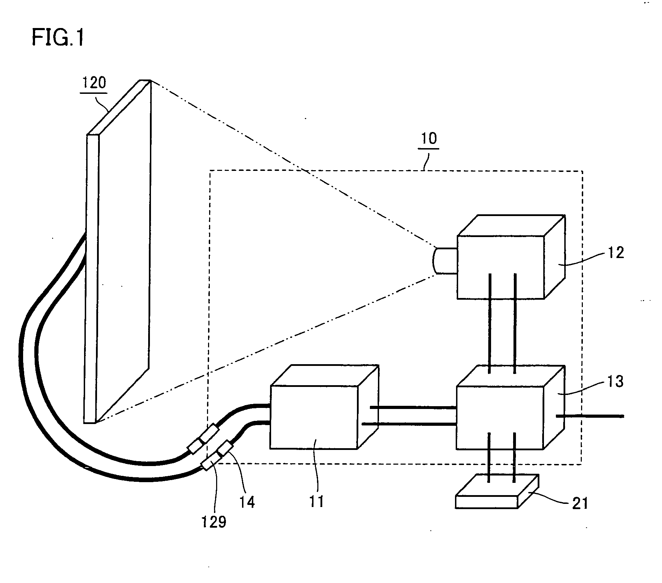

Fig. 1 is a configuration diagram showing a solar battery module evaluation apparatus 10 according to a present, first embodiment of the present invention.

Solar battery module evaluation apparatus 10 includes a power supply unit 11 supplying electric power by applying a forward bias voltage to an output terminal 129 of a solar battery module 120, a camera 12 picking up an optical image that appears as a result of supply of electric power, and a processing unit 13 performing pattern recognition of the image picked up by camera 12 based on data of that image and outputting pattern information indicating whether solar battery module 120 is defective or not to a warning light 602 or the like which will be described later. In inspecting solar battery module 120, output terminal 129 of solar battery module 120 and a power supply terminal 14 forming a part of power supply unit 11 are connected to each other for use. In the present embodiment, power supply unit 11 supplies energy to a flat panel type solar battery module 120 made of silicon. As power supply unit 11 supplies electric power, a solar battery cell 100 constituting solar battery module 120 emits light through electroluminescence phenomenon.

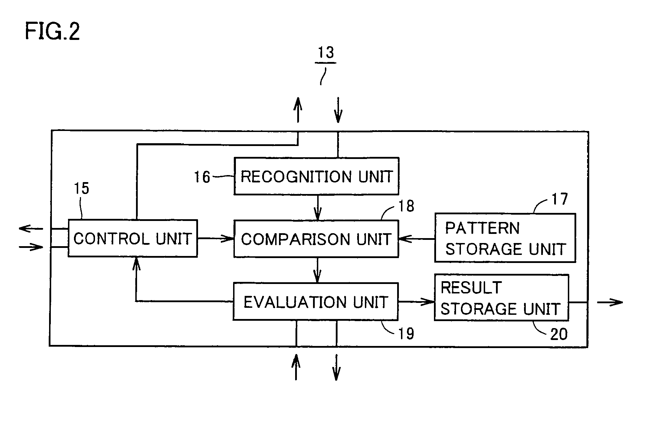

Fig. 2 is a control block diagram of processing unit 13. Referring to Fig. 2, processing unit 13 includes a control unit 15 controlling power supply unit 11, camera 12 and processing unit 13 itself, a recognition unit 16 performing pattern recognition of a shape of solar battery cell 100 based on the data of the image picked up by camera 12, a pattern storage unit 17 storing data of a reference pattern, a comparison unit 18 comparing a portion of which pattern has been recognized by recognition unit 16 in the image picked up by camera 12 with the reference pattern, and an evaluation unit 19 outputting pattern information indicating whether solar battery module 120 is defective or not. In the present embodiment, the "reference pattern" refers to an optical image that appears as a result of supply of electric power to a defective solar battery module.

In the present embodiment, processing unit 13 includes a result storage unit 20 storing pattern information indicating whether solar battery module 120 is defective or not. Result storage unit 20 includes a data extraction unit extracting data necessary for providing feedback that the solar battery module is defective to an apparatus for manufacturing solar battery module 120, and a data transmission unit transmitting extracted data to an external apparatus.

Processing unit 13 is preferably connected to an external memory 21. External memory 21 is a device storing information output from evaluation unit 19. When data of a process management sheet is stored in external memory 21 and such external memory 21 is provided for each solar battery module 120, a module ID number may also be stored in that external memory 21. If the module ID number is stored in advance in external memory 21, processing unit 13 can preferably recognize the module ID number.

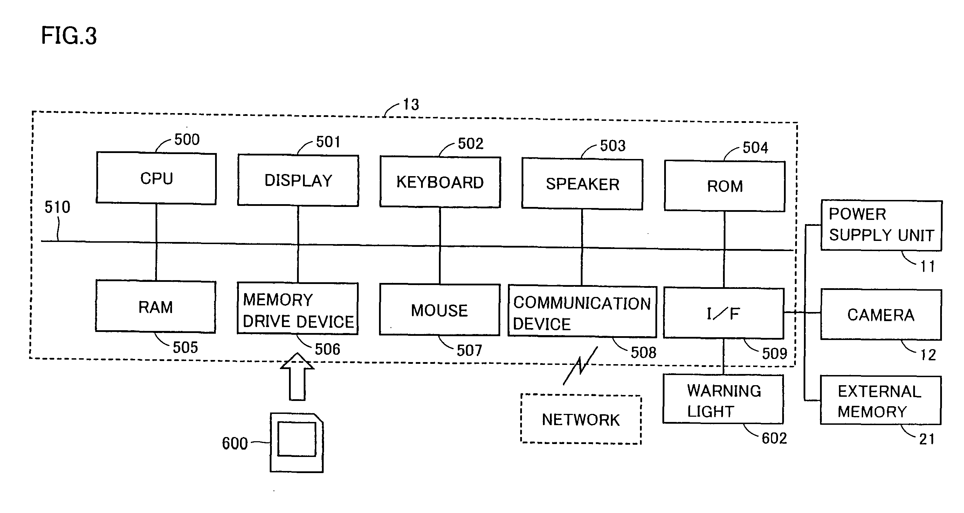

Fig. 3 is a control block diagram of computer hardware implementing processing unit 13. In the present embodiment, each unit implementing processing unit 13 is a virtual circuit implemented by the computer hardware shown in Fig. 3. Referring to Fig. 3, the computer hardware implementing processing unit 13 includes a CPU (central processing unit) 500, a display 501, a keyboard 502, a speaker 503, a ROM (Read Only Memory) 504, a RAM (Random Access Memory) 505, a memory drive device 506, a mouse 507, a communication device 508, an interface 509, and a bus 510. CPU 500 obtains a program in which each processing procedure is described from ROM 504. CPU 500 executes the program. In addition, CPU 500 communicates data with display 501, keyboard 502, speaker 503, ROM 504, RAM 505, memory drive device 506, mouse 507, communication device 508, and interface 509. Display 501 displays data to be displayed as an image. The data is thus output. Keyboard 502 detects a key that has been pressed, through a mechanical or electronic switch or the like. A user's instruction is thus accepted. The user's instruction is output to CPU 500 and the like through bus 510. Speaker 503 is an apparatus converting an audio signal to voice and sound for output. ROM 504 stores information essential for the computer in Fig. 3 to perform information processing. RAM 505 is also used as a device storing data necessary for executing a program. Memory drive device 506 reads a program from a removable recording medium such as a PC (Personal Computer) card 600. Mouse 507 allows a user to designate an icon and to input other commands by clicking or dragging. Communication device 508 communicates data with a manufacturing apparatus or the like connected through wireless or wired connection. Interface 509 outputs a control signal to warning light 602 or the like. Information is thus output to warning light 602 or the like. Bus 510 connects devices constituting the computer to one another.

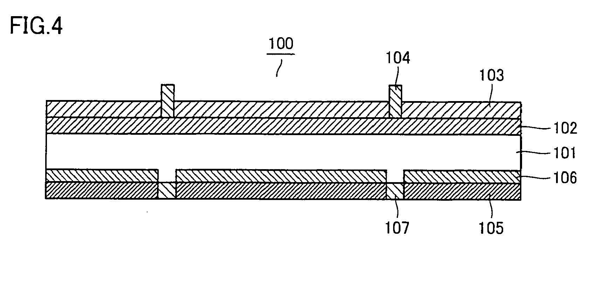

Fig. 4 is a schematic cross-sectional view of solar battery cell 100 according to the present embodiment. Solar battery cell 100 used in the present embodiment will be described with reference to Fig. 4.

In the present embodiment, solar battery cell 100 is formed of a polycrystalline silicon substrate of 155mm square and a thickness of 200µm. A pn junction is formed by forming an n+ layer 102 on a light-receiving surface of a p-type silicon substrate 101 in solar battery cell 100. An anti-reflection coating 103, a bus bar electrode 104, and a finger electrode 108 which will be described later are formed on a surface of n+ layer 102. A p+ layer 106 is formed on a back surface opposite to the light-receiving surface of p-type silicon substrate 101. An aluminum electrode 105 and a silver electrode 107 are formed on the back surface of p-type silicon substrate 101.

Though not necessarily essential, in the present embodiment, a surface of bus bar electrode 104 and a surface of silver electrode 107 are coated with a solder. A solder coating method includes a method of immersing bus bar electrode 104 and silver electrode 107 in a molten solder bath.

After solar battery cell 100 is manufactured, a current-voltage characteristic (IV characteristic) of solar battery cell 100 is determined. In order to determine the IV characteristic, a solar simulator is used to irradiate solar battery cell 100 with simulated solar rays. After the IV characteristic is determined, only a solar battery cell satisfying prescribed conversion efficiency among solar battery cells 100 is supplied to a module step.

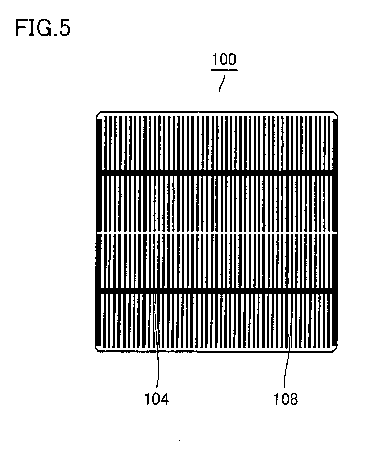

Fig. 5 is a diagram showing a pattern of bus bar electrode 104 and finger electrode 108. In the present embodiment, bus bar electrode 104 and finger electrode 108 are formed on the light-receiving surface of p-type silicon substrate 101. Bus bar electrode 104 is implemented by an electrode having a relatively large width and a linear shape and made of silver. Finger electrode 108 is implemented by a plurality of electrodes that extend from bus bar electrode 104, have a relatively small width and a linear shape, and are made of silver. In solar battery cell 100 according to the present embodiment, two bus bar electrodes 104 are formed on the light-receiving surface. A plurality of finger electrodes 108 extending from each bus bar electrode 104 are separated at the center of the cell.

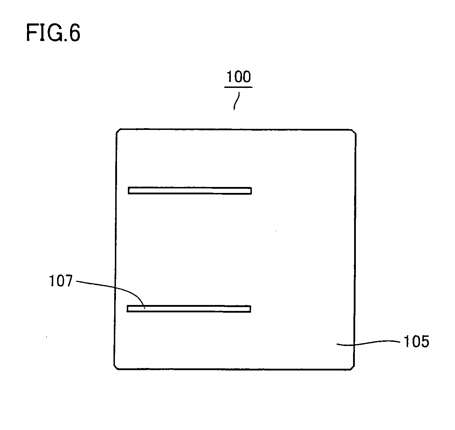

Fig. 6 is a diagram showing a pattern of aluminum electrode 105 and rectangular silver electrode 107 formed on the back surface of p-type silicon substrate 101. Silver electrode 107 is arranged in line with arrangement of bus bar electrode 104 such that it is located closer to one side with respect to the center of solar battery cell 100. The reason why silver electrode 107 is provided in addition to aluminum electrode 105 is because it is difficult to coat aluminum electrode 105 with solder and silver electrode 107 readily coated with solder is necessary.

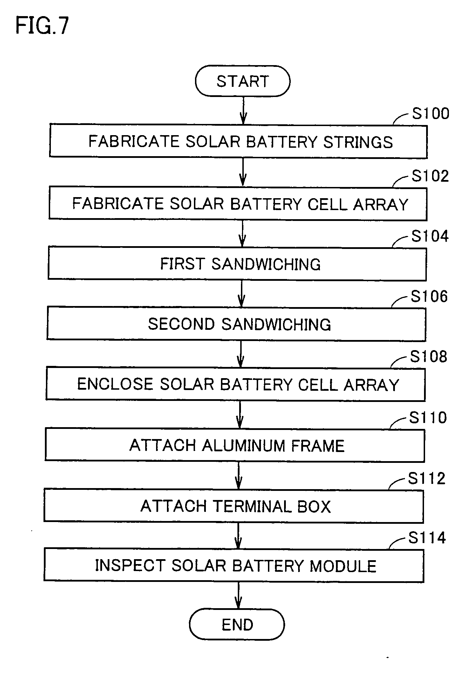

An exemplary method of manufacturing solar battery module 120 with solar battery cells 100 is shown with reference to Figs. 7 to 33. Fig. 7 is a flowchart showing a procedure for manufacturing solar battery module 120.

In step S 100, the manufacturing apparatus connects one end of an interconnector 109 formed of a conductive member to bus bar electrode 104 of solar battery cell 100 and connects the other end thereof to silver electrode 107 of another solar battery cell 100.

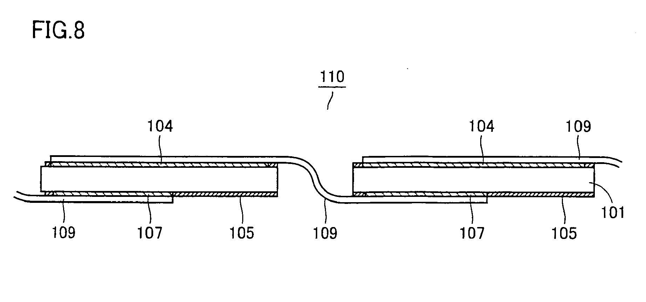

Fig. 8 is a schematic cross-sectional view of a solar battery string 110 including solar battery cells 100 connected in series. As can clearly be seen from Fig. 8, interconnector 109 fixed to bus bar electrode 104 on the light-receiving surface of solar battery cell 100 by means of solder or the like is also fixed to silver electrode 107 of adjacent solar battery cell 100 by means of solder or the like. It is noted that n+ layer 102 and p+ layer 106 are not shown in Fig. 8. In the present embodiment, interconnector 109 is implemented by a conductive member (copper wire) plated with solder. Interconnector 109 and two solar battery cells 100 are connected to each other through heating of bus bar electrode 104 of one solar battery cell 100, silver electrode 107 of another solar battery cell 100, and interconnector 109 while interconnector 109 lies on bus bar electrode 104 and silver electrode 107. Solar battery cells 100 are thus connected in series through the conductive member, to thereby fabricate solar battery string 110.

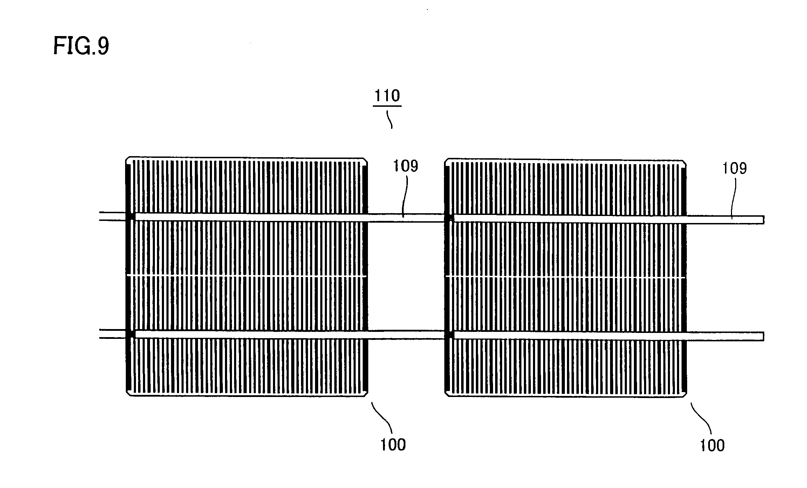

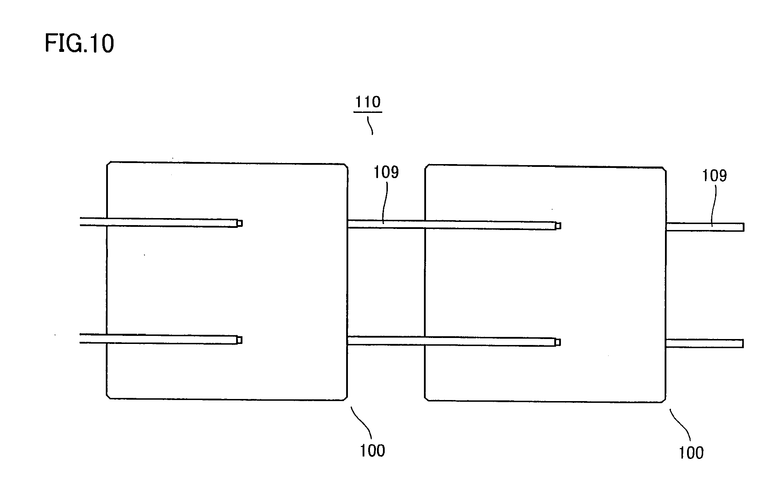

Fig. 9 is a plan view of a part of solar battery string 110 when viewed from a light-receiving surface side. Fig. 10 is a plan view of a part of solar battery string 110 when viewed from the back surface side. As can clearly be seen from Figs. 9 and 10, in the present embodiment, interconnector 109 on the light-receiving surface side is connected to bus bar electrode 104 across solar battery cell 100 from one end to the other end, and interconnector 109 on the side opposite to the light-receiving surface is connected to silver electrode 107 across an area from one end to the vicinity of the center of the back surface of solar battery cell 100.

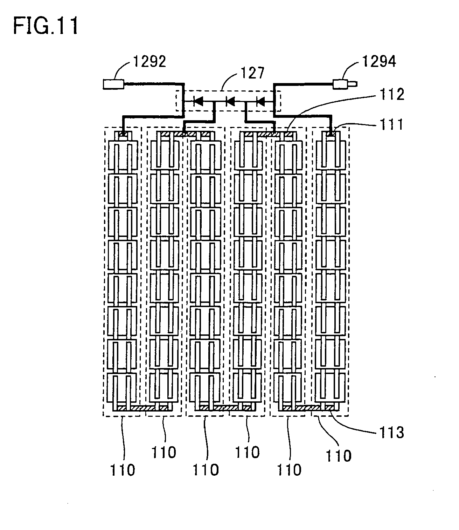

In step S102, the manufacturing apparatus arranges solar battery strings 110 and connects in series interconnectors 109 projecting from opposing ends of solar battery string 110 to interconnectors 109 projecting from opposing ends of another solar battery string 110, by using a wiring member 111, a wiring member 112 and a wiring member 113 implemented by a conductive member. A method for connecting interconnector 109 is not particularly limited. For example, the method may be soldering. Here, a bypass diode 130 which will be described later is also attached. Through this step, a plurality of solar battery strings 110 form a solar battery cell array 123. Fig. 11 is a diagram schematically showing arrangement of solar battery strings 110 and a connection state of wiring member 111, wiring member 112, and wiring member 113 in solar battery module 120.

In step S104, the manufacturing apparatus sandwiches solar battery cell array 123 between an EVA (Ethylene Vinyl acetate) film 122 and an EVA film 124 serving as an enclosing material.

In step S106, the manufacturing apparatus sandwiches solar battery cell array 123 sandwiched between EVA film 122 and EVA film 124, between a glass plate 121 and a back film 125.

In step S108, the manufacturing apparatus removes air bubbles introduced between EVA film 122 and EVA film 124 through pressure reduction, and heats solar battery cell array 123 sandwiched between glass plate 121, EVA film 122, EVA film 124, and back film 125. EVA film 122 and EVA film 124 are hardened in this step, so that solar battery string 110 is enclosed with EVA. Solar battery module 120 is thus fabricated.

In step S 110, the manufacturing apparatus attaches an aluminum frame 1262 and an aluminum frame 1264 to solar battery module 120.

In step S 112, the manufacturing apparatus attaches a terminal box 127 provided with a cable 128 to solar battery module 120 to which aluminum frame 1262 and aluminum frame 1264 have been attached.

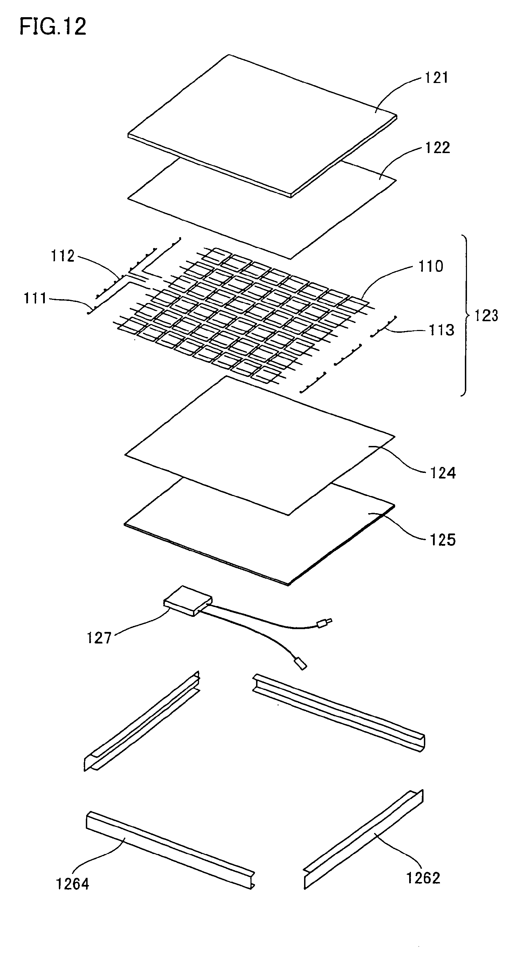

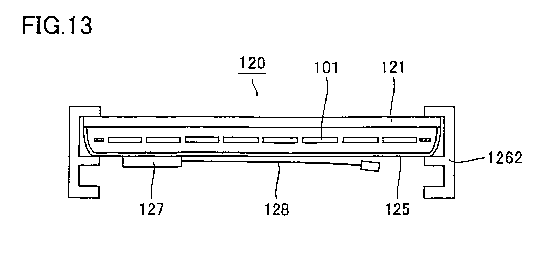

Fig. 12 is a diagram illustrating a structure of solar battery module 120. Fig. 13 is a cross-sectional view of solar battery module 120. It is noted that interconnector 109, wiring in terminal box 127 and the like are not shown in Fig. 13.

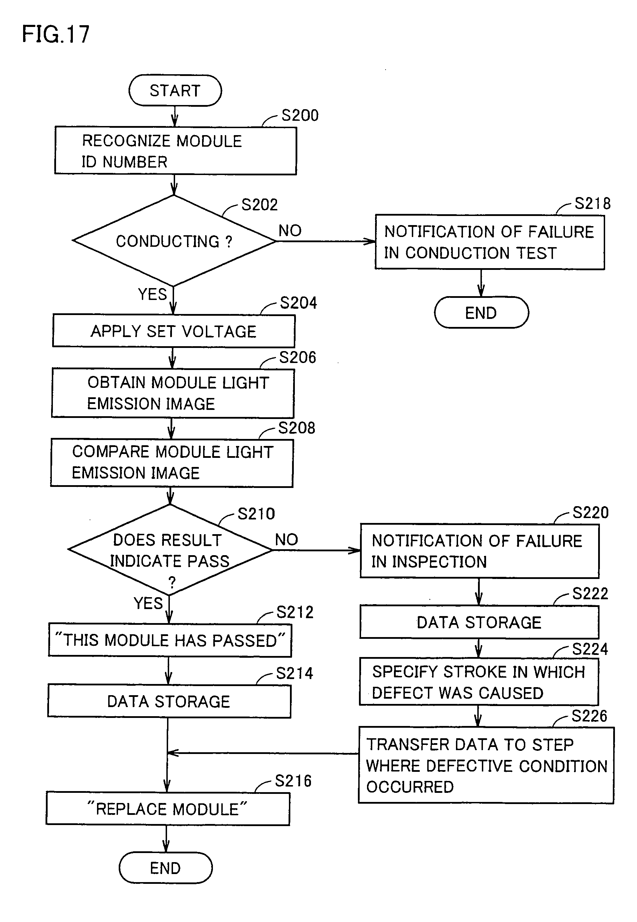

In step S 114, solar battery module evaluation apparatus 10 inspects solar battery module 120 and transmits information in accordance with a result of inspection to the manufacturing apparatus. This step corresponds to the processing from step S200 to step S226 shown in a flowchart in Fig. 17 which will be described later.

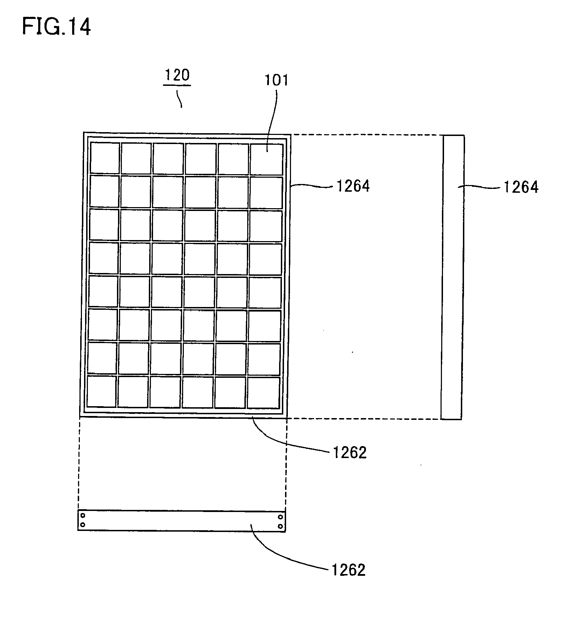

Fig. 14 is a diagram illustrating completed solar battery module 120 with a third angle projection method. In Fig. 14, the plan view, the front view, and the right side view are connected to one another with a dashed line. As shown in Fig. 14, aluminum frame 1262 and aluminum frame 1264 of solar battery module 120 are fixed to each other with a screw or the like.

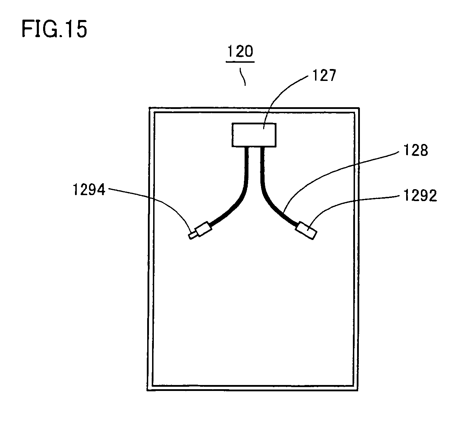

Fig. 15 is a diagram showing a bottom surface of solar battery module 120. One ends of two cables 128 are connected to terminal box 127. The other ends of these cables 128 include a female terminal 1292 and a male terminal 1294 respectively. Each of female terminal 1292 and male terminal 1294 represents one type of output terminal 129.

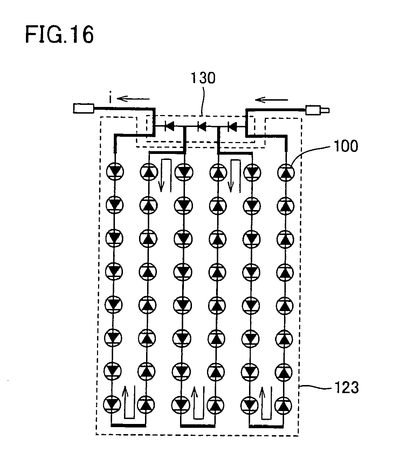

Fig. 16 is a diagram showing as a circuit diagram, arrangement of solar battery cells 100 and a connection state of bypass diode 130 in solar battery module 120. An arrow in Fig. 16 shows a current flow when electric power generation is normally performed. If a dead leaf or the like partially casts shadow over the light-receiving surface of solar battery cell 100, an amount of electric power generation in that portion is lowered and electric resistance of that solar battery cell 100 becomes greater. As the electric resistance of solar battery cell 100 becomes greater, that solar battery cell 100 blocks the current and generates heat due to resistance loss. In order to avoid blocking of the current or heat generation, solar battery module 120 has a bypass diode function for bypassing solar battery cell 100 over which shadow is partially cast. In the present embodiment, three bypass diodes 130 are attached to solar battery module 120 as a current path for bypassing solar battery string 110 of which amount of electric power generation has been lowered.

After solar battery module 120 is completed, solar battery module 120 not corresponding to the pattern mode described above is irradiated with simulated solar rays by using a solar simulator. Here, the IV characteristic of solar battery module 120 is inspected. After the IV characteristic is inspected, only solar battery module 120 of which IV characteristic satisfies criteria is used for production of the solar power generation system.

Fig. 17 is a flowchart showing a procedure for controlling processing for inspecting solar battery module 120 by using solar battery module evaluation apparatus 10. In the present embodiment, the inspection processing is started, for example, by pressing a not-shown inspection start button of solar battery module evaluation apparatus 10. In addition, if inspection is managed by external memory 21, attachment of external memory 21 to processing unit 13 may be regarded as trigger for starting inspection. Here, a result of inspection may subsequently be stored in external memory 21, assuming that a module ID number has been recognized based on the fact that attachment of external memory 21 was recognized. A specific procedure in the inspection processing will be described with reference to Fig. 17.

In step S200, a module ID number which is an identification code of solar battery module 120 is identified. A method for identifying the module ID is not particularly limited. For example, the method includes the following two methods. The first method is a method in which an image printed or pictographically formed on a light-receiving glass surface and picked up by camera 12 is identified by CPU 500 operating as a device included in recognition unit 16. The second method is a method in which information stored in external memory 21, a bar code, an IC tag, or the like is identified or read by CPU 500 operating as a device included in evaluation unit 19. In the present embodiment, it is assumed that the second method is adopted. When camera 12 picks up an image of the module ID number, CPU 500 operating as recognition unit 16 preferably processes the module ID number as directory management information. Here, the module ID number is preferably temporarily stored in RAM 505 operating as recognition unit 16, such that the module ID number is associated with data of an image subsequently picked up by camera 12. Here, when camera 12 picks up an image, data representing that image is stored in association with the data of the module ID number. On the other hand, when the module ID number is identified based on external information such as information in external memory 21, the module ID number is preferably temporarily stored in RAM 505 operating as evaluation unit 19. Finally, the module ID number is preferably stored in RAM 505 operating as result storage unit 20 in association with information indicating whether there is a defective portion in solar battery module 120 or not.

In step S202, CPU 500 operating as control unit 15 determines whether solar battery module 120 is conducting or not. In the present embodiment, conduction is checked in the following procedure. The first procedure is a procedure in which CPU 500 operating as control unit 15 measures a short circuit current (Isc) or an open circuit voltage (Voc) of a solar battery with an ammeter or a voltmeter contained in power supply unit 11. The second procedure is a procedure in which these measurement values are checked by control unit 15. When the solar battery module is conducting (YES in step S202), the process proceeds to step S204. Otherwise (NO in step S202), the process proceeds to step S218.

In step S204, CPU 500 operating as control unit 15 issues to power supply unit 11, a command to apply a voltage. Power supply unit 11 applies a prescribed forward bias voltage to power supply terminal 14. Electric power is thus supplied to solar battery module 120. In this step, as the supplied electric power is electric power for having solar battery module 120 emit light through electroluminescence phenomenon, the voltage and current thereof are adapted to the specifications of solar battery module 120. In order to have the voltage and current adapted to the specifications, a current value may be adjusted by sensing a current that flows through solar battery module 120 at the time of application of the voltage and controlling a voltage value. In applying the forward bias voltage, the forward bias voltage may be applied in a stepwise fashion, while assuming a pattern mode. When the voltage is applied in a stepwise fashion, the number of steps in increasing the voltage value may be equal to the number of current paths resulting from division by bypass diode 130.

In step S206, camera 12 picks up, as an image, light that appears from a planar portion, that is, the light-receiving surface, of solar battery cell 100 as a result of electric power of the forward bias voltage. Data of the picked-up image is sent to CPU 500 operating as recognition unit 16. In the present embodiment, CPU 500 operating as recognition unit 16 recognizes a portion of solar battery cell 100 in the picked-up image. Processing unit 13 can thus operate as a device outputting pattern information indicating whether solar battery module 120 is defective or not, based on the data of the optical image of one solar battery cell 100 that appears as a result of supply of electric power. In addition, in the present embodiment, CPU 500 operating as recognition unit 16 recognizes a position of an electrode based on shadow in the picked-up image cast by the electrode constituting solar battery cell 100. Processing unit 13 can thus output pattern information indicating whether solar battery module 120 is defective or not, based on the data of the image including shadow cast by the electrode of solar battery cell 100.

When the position of the electrode is recognized, CPU 500 operating as recognition unit 16 recognizes an orientation of solar battery module 120 based on the position thereof. This is because, where adjacent solar battery cells 100 are connected to each other through a plurality of interconnectors 109 and connection of one interconnector 109 is poor, from which manufacturing apparatus connecting interconnector 109 such poor connection resulted can be specified if the position of the electrode is recognized. In addition, as the shape of the electrode on the side opposite to the light-receiving surface is relatively readily characterized, CPU 500 operating as recognition unit 16 according to the present embodiment recognizes the orientation of the solar battery module by recognizing the position of the electrode on the back surface of solar battery cell 100. Processing unit 13 can thus operate as a device outputting pattern information indicating whether solar battery module 120 is defective or not by using the data of the image including shadow of the electrode of solar battery cell 100.

In the present embodiment, in recognizing a portion of solar battery cell 100 or a position of an electrode, CPU 500 operating as recognition unit 16 specifies a coordinate of that portion. In specifying a cause of defect, CPU 500 operating as recognition unit 16 can thus specify the cause of defect by using the coordinate of solar battery cell 100 where the defect was caused.

In step S208, CPU 500 operating as comparison unit 18 compares a pattern of the image identified by CPU 500 operating as recognition unit 16 with the reference pattern. A comparison method is not particularly limited, so long as at least a part of the pattern of the image identified by recognition unit 16 is compared with the reference pattern. For example, the method includes a method of extracting a pattern corresponding to the reference pattern for each solar battery cell 100 or to the reference pattern for each solar battery string 110 and performing coding for each solar battery cell 100 or solar battery string 110, and a method of superimposing a portion corresponding to the reference pattern, in the pattern of the image identified by recognition unit 16. In the present embodiment, it is assumed that the former method is adopted. In the present embodiment, if a score of matching between the pattern of the image identified by recognition unit 16 and any of the reference patterns is not smaller than a threshold value, CPU 500 operating as comparison unit 18 regards these images as matching with each other.

If the latter method is adopted, the pattern may be superimposed for each solar battery cell 100 or for each solar battery string 110. When the latter method is adopted, the reference pattern for each solar battery cell 100 or a set of patterns for respective solar battery cells 100 may be employed as the reference pattern stored in ROM 504 operating as pattern storage unit 17. If the set of patterns for respective solar battery cells 100 is employed as the reference pattern stored in pattern storage unit 17, the reference pattern is preferably such a pattern that the patterns for respective solar battery cells 100 are aligned in a longitudinal direction of solar battery string 110. If such a pattern that the patterns for respective solar battery cells 100 are aligned in a longitudinal direction of solar battery string 110 is employed as the reference pattern stored in pattern storage unit 17, the number of aligned patterns for respective solar battery cells 100 is equal to the number of solar battery cells 100 constituting solar battery string 110.

In step S210, CPU 500 operating as evaluation unit 19 specifies whether there is a defective portion in solar battery module 120 or not by using a result of pattern comparison obtained in step S208. If there is a defective portion, CPU 500 operating as evaluation unit 19 specifies a defective portion and also a cause of defect.

The following modes are possible as pattern modes representing types of defect caused in solar battery module 120. A pattern mode "A1" and a pattern mode "A2" indicate crack of solar battery cell 100. A pattern mode "B" indicates such a defect that finger electrode 108 closer to the center of solar battery cell 100 lying across bus bar electrode 104 is open. A pattern mode "C" indicates poor connection of wiring member 111, wiring member 112 or wiring member 113 with interconnector 109. A pattern mode "D" indicates short-circuiting between the electrodes of solar battery cells 100. A pattern mode "E" indicates reverse connection of solar battery string 110, short-circuiting of bypass diode 130, or open of solar battery cell 100. Relation between these pattern modes and causes thereof is considered as follows.

A cause I is stress during lamination in the enclosing step for fabricating solar battery module 120, which causes crack in solar battery cell 100.

A cause II is deterioration in the shape of a printing pattern, a trouble in squeegeeing control, or shortage in an amount of silver paste in the step of forming an electrode of solar battery cell 100 (the step of printing silver paste with screen printing or the like), which causes open of bus bar electrode 104 and finger electrode 108 or insufficient width of an electric wire of finger electrode 108 (that is, a phenomenon in which a resistance of the electric wire of finger electrode 108 exceeds a tolerable value).

A cause III is poor soldering between wiring member 111, wiring member 112 or wiring member 113 and interconnector 109, which is caused in the step of soldering wiring member 111, wiring member 112 and wiring member 113 implemented by a conductive member to interconnectors 109 projecting from opposing ends of solar battery string 110 and interconnectors 109 projecting from opposing ends of another solar battery string 110. The soldering step is a part of the step of connecting wiring member 111, wiring member 112 or wiring member 113 to solar battery string 110. Such poor soldering causes a phenomenon in which only a half plane of solar battery cell 100 connected to one bus bar electrode 104 generates electric power.

A cause IV is wrap-around of a wafer edge by the solder in the step of fabricating solar battery string 110, which causes short-circuiting between the electrode on the light-receiving surface and the electrode on the back surface.

A cause V-1 is incorrect setting of solar battery string 110 (connection of solar battery string 110 in a direction reverse to a correct direction), which is caused in the step of soldering wiring member 111, wiring member 112 and wiring member 113 implemented by a conductive member to interconnectors 109 projecting from opposing ends of solar battery string 110 and interconnectors 109 projecting from opposing ends of another solar battery string 110.

A cause V-2 is short-circuiting of bypass diode 130.

A cause V-3 is non-conduction such as disconnection of interconnector 109 connected to one solar battery cell 100, which causes a phenomenon that electric power from a plurality of solar battery strings 110 is not output.

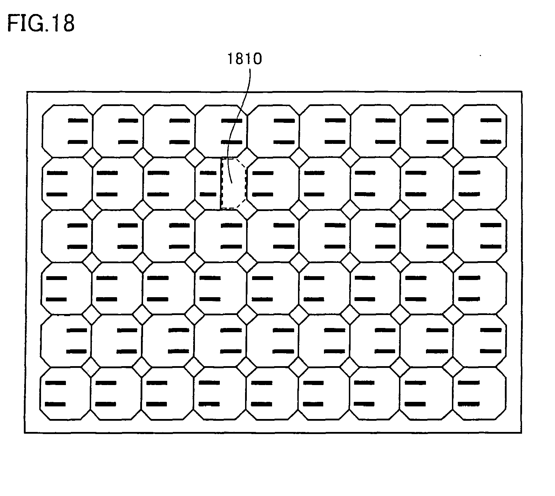

Figs. 18 to 22 show exemplary images obtained by camera 12.

Fig. 18 illustrates a first exemplary image when a defect is caused. In the present embodiment, a defect 1810 shown in Fig. 18 is categorized into pattern mode "A1".

A crack shown in Fig. 18 extends in a direction intersecting interconnector 109. A back surface electrode and a light-receiving surface electrode located on the left-half plane with respect to the center of solar battery cell 100 are connected to adjacent solar battery cells 100 through interconnectors 109 respectively. It seems that electric power generation in this solar battery cell 100 is performed in the left half in Fig. 18 and the right half does not contribute to electric power generation. Therefore, in inspection, light emission from the left-half plane is more intense than that from surrounding solar battery cells 100 and the right-half plane does not emit light. In such a state, even though the output characteristic immediately after manufacturing satisfies prescribed criteria, cracked solar battery cell 100 generates heat as a resistor. When the light emission intensity of solar battery cell 100 in which cell crack corresponding to pattern mode "A1" or pattern mode "A2" occurred is partially greater than that of surrounding cells, it supports the fact that cracked solar battery cell 100 generates heat during electric power generation. If cracked solar battery cell 100 generates heat as a resistor, a connection point of interconnectors 109, EVA film 122, EVA film 124, or the like may suffer from deterioration over time. In that event, output of solar battery module 120 as a whole may lower due to lowering in the output of solar battery string 110, which is not preferable.

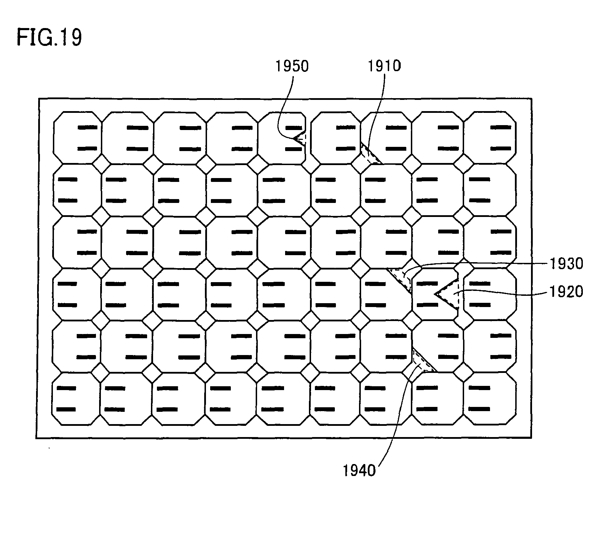

Fig. 19 illustrates a second exemplary image when a defect is caused. In the present embodiment, in solar battery cells 100 shown in Fig. 19, a defect 1910 and a defect 1950 in the third and fifth columns from the right and in the first row from the top respectively, a defect 1920 and a defect 1930 in the second and third columns from the right and in the fourth row from the top respectively, and a defect 1940 in the second column from the right and in the fifth row from the top are categorized into pattern mode "A2".

A cell crack corresponding to pattern mode "A2" refers to such a state that solar battery cell 100 cracks in a direction parallel to interconnector 109 or such a state that the solar battery cell cracks diagonally to interconnector 109. When the cell crack corresponding to pattern mode "A2" is caused, an amount of electric power generation of solar battery cell 100 lowers. Adjacent solar battery cells 100 identical in the pattern mode indicate that solar battery cells 100 have cracked due to local stress in laminating solar battery string 110. By thus analyzing arrangement of the pattern mode, the step causing a defect may be specified.

In the present embodiment, defects in the cell in the first row from the top and in the rightmost column, in the cell in the second row from the top and in the third column from the left, and in the cells in the first row from the bottom and in the fourth and sixth columns from the right, among solar battery cells 100 shown in Fig. 19, are categorized into pattern mode "B".

As to defects corresponding to pattern mode "B", an apparatus that caused the defect can be estimated by determining a direction of solar battery cell 100. In order to determine a direction of solar battery cell 100, relation between a printing direction and a portion (direction) where finger electrode 108 is open should only be obtained. In order to obtain the relation, recognition unit 16 should only recognize shade of an electrode pattern. Naturally, it is CPU 500 that actually recognizes the shade.

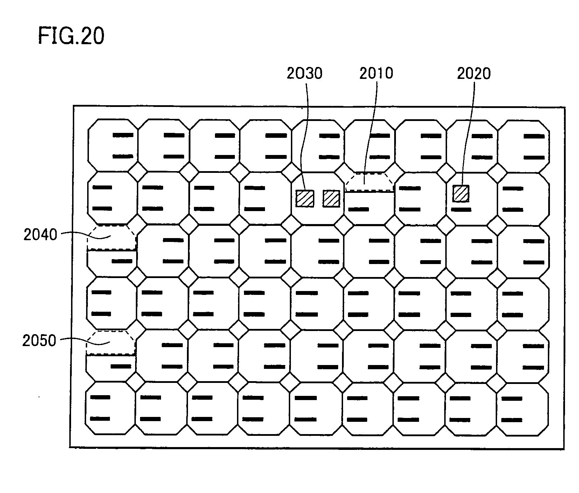

Fig. 20 illustrates a third exemplary image when a defect is caused. In the present embodiment, a defect 2010 in the second row from the top and in the fourth column from the right in solar battery cells 100 shown in Fig. 20 is categorized into pattern mode "A2". In the present embodiment, a defect 2020 and a defect 2030 in the second row from the top and in the second and fifth columns from the right respectively in solar battery cells 100 shown in Fig. 20 are categorized into pattern mode "B". In the present embodiment, a defect 2040 and a defect 2050 in the first column from the left and in the third and fifth rows from the top respectively in solar battery cells 100 shown in Fig. 20 are categorized into pattern mode "C".

Pattern mode "C" appears as an image of solar battery cell 100 at the end of solar battery string 110, in which the half plane of solar battery cell 100 connected to one bus bar electrode 104 is dark and the half plane thereof connected to another bus bar electrode 104 is bright. An image of solar battery cell 100 adjacent to solar battery cell 100 in which a defect corresponding to pattern mode "C" occurred is an image where brightness is even. This is because, in solar battery cell 100 in which a defect corresponding to pattern mode "C" occurred, an equally divided current path is formed by aluminum electrode 105 on the entire back surface.

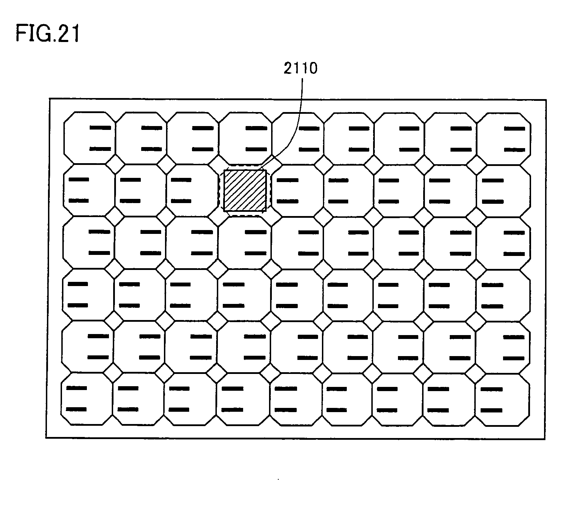

Fig. 21 illustrates a fourth exemplary image when a defect is caused. In the present embodiment, a defect in the second row from the top and in the fourth column from the right in solar battery cells 100 shown in Fig. 21 is categorized into pattern mode "A2". In the present embodiment, a defect 2110 in the second row from the top and in the fourth column from the left in solar battery cells 100 shown in Fig. 21 is categorized into pattern mode "D".

Pattern mode "D" appears as an image of solar battery cell 100 darker as a whole than adjacent solar battery cell 100. The cause of a defect corresponding to pattern mode "D" may be short-circuiting between a positive electrode and a negative electrode. The cause of short-circuiting between the positive electrode and the negative electrode may be wrap-around of a wafer edge by the solder in the step of forming solar battery string 110.

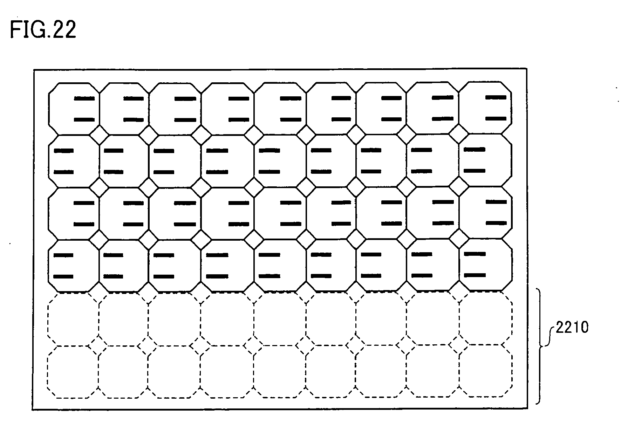

Fig. 22 illustrates a fifth exemplary image when a defect is caused. In the present embodiment, a defect 2210 in solar battery string 110 in two entire rows as shown in Fig. 22 is categorized into pattern mode "E".

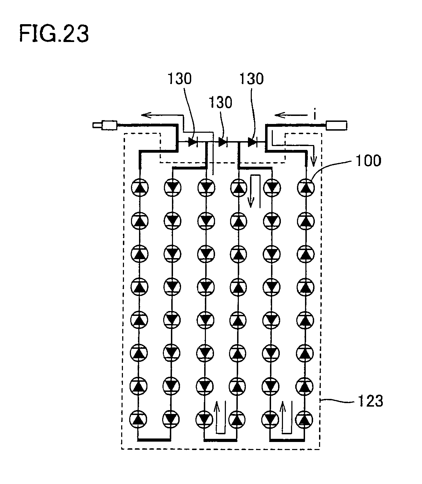

The cause of a defect corresponding to pattern mode "E" is generation of a current path via bypass diode 130 as shown in Fig. 23. Fig. 23 is a diagram showing as a circuit diagram, generation of a current path via bypass diode 130 in solar battery module 120. Here, the current does not flow through solar battery strings 110 in two columns on the left among solar battery strings 110 shown in Fig. 23. One cause of generation of the current path via bypass diode 130 may be partially insufficient soldering between interconnector 109 and wiring member 11 or the like in the following step, that is, the step of soldering wiring member 111, wiring member 112 and wiring member 113 to interconnectors 109 projecting from opposing ends of solar battery string 110 and interconnectors 109 projecting from opposing ends of another solar battery string 110.

As can clearly be seen from Figs. 18 to 22, shade of the electrode pattern of solar battery cell 100 is observed in the image obtained by solar battery module evaluation apparatus 10. The shade of the electrode on the back surface of solar battery cell 100 is clearly seen. This is because such a phenomenon that light emission from silver electrode 107 on the back surface of solar battery cell 100 is less and such a phenomenon that interconnector 109 on the electrode on the light-receiving surface side of solar battery cell 100 blocks light emission of solar battery cell 100 are combined. In the present embodiment, an exemplary solar battery module, in which 54 solar battery cells are connected in series by alternately arranging in six columns, solar battery strings different in orientation each including 9 solar battery cells connected in series, has been described. If a manufacturing line dedicated for a string in an odd-numbered column and a manufacturing line dedicated for a string in an even-numbered column are employed, the manufacturing line can be specified by recognizing an image pattern including shade of these electrodes for each string.

In addition, as can clearly be understood from the description above, types of images picked up when solar battery cell 100 is defective are various. Even though the types of picked-up images may be various, what kind of defect is included in solar battery cell 100 can be specified based on these images, by performing a comparison operation through information processing or the like using a computer. In addition, if an image for each cell is to be recognized, adjacent solar battery cells can be compared with each other, and based on this comparison, a defective cell such as a cracked cell can also be detected.

In addition, adjacent solar battery cells can be compared with each other with their orientations being aligned by recognizing shade of the electrode pattern of solar battery cell 100, so that a defective cell can also accurately be detected.

In solar battery module 120, solar battery strings 110 different from each other in a direction of arrangement are alternately arranged. Thus, when solar battery strings 110 different from each other in the direction of arrangement are manufactured by two manufacturing lines, in which manufacturing line defective solar battery string 110 was fabricated can be determined by using the following method. Specifically, the method is a method of determining a direction of solar battery cell 100 by recognizing shade of the electrode pattern. By determining in which manufacturing line defective solar battery string 110 was fabricated, feedback to the manufacturing process can further effectively be provided.

In step S210, CPU 500 operating as evaluation unit 10 determines whether solar battery module 120 is defective or not, that is, whether solar battery module 120 has passed the inspection or not, based on the result of the comparison in step S208. If solar battery module 120 is determined as pass (YES in step S210), the process proceeds to step S212. Otherwise, (NO in step S210), the process proceeds to step S220.

In step S212, display 501 and interface 509 operating as evaluation unit 19 output information indicating pass in the inspection under the control of CPU 500 similarly operating as evaluation unit 19. The information indicating pass in the inspection is indicated, for example, by an indication that "this module has passed" or illumination of warning light 602 or the like.

In step S214, CPU 500 operating as evaluation unit 19 causes RAM 505 operating as result storage unit 20 to store information indicating the result of pattern comparison obtained in step S208 together with the module ID number. In the present embodiment, the information actually stored as "information indicating the result of pattern comparison" is information indicating contents of a pattern mode or information indicating contents of a defective mode.

In step S216, display 501 and interface 509 operating as evaluation unit 19 output information to an operator of solar battery module evaluation apparatus 10 under the control of CPU 500 similarly operating as evaluation unit 19. In the present embodiment, the information is output as display of character strings such as "replace the module" or illumination of warning light 602.

In step S218, display 501 and interface 509 operating as evaluation unit 19 output information to an operator of solar battery module evaluation apparatus 10 under the control of CPU 500 similarly operating as evaluation unit 19. In the present embodiment, the information is output as display of character strings such as "set again the module" or illumination of warning light 602.

In step S220, display 501 and interface 509 operating as evaluation unit 19 output information indicating failure in the inspection under the control of CPU 500 similarly operating as evaluation unit 19. In the present embodiment, the information is output as display of character strings such as "this module has failed" or illumination of warning light 602.

In step S222, CPU 500 operating as evaluation unit 19 causes RAM 505 operating as result storage unit 20 to store information on pass or fail in the inspection (a defective portion in solar battery module 120, a pattern mode, and the like) together with the module ID number.

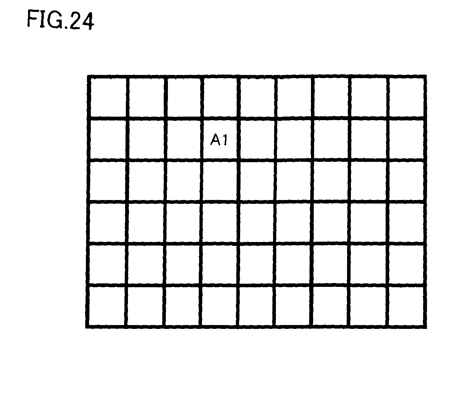

In step S224, CPU 500 operating as evaluation unit 19 specifies the step that resulted in a defect, by analyzing information such as a pattern mode obtained in step S208 or pattern modes accumulated in result storage unit 20. Figs. 24 to 33 show processing performed by CPU 500 that operates as evaluation unit 19 on the images obtained by solar battery module evaluation apparatus 10 according to the present embodiment.

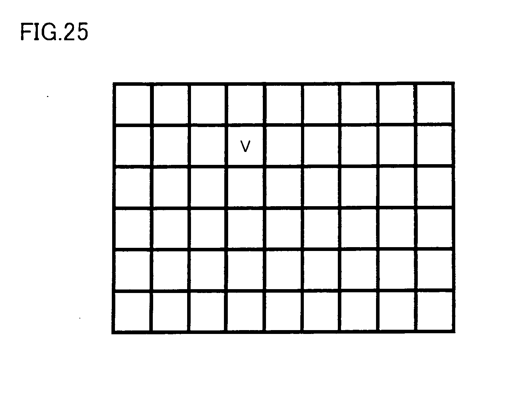

Fig. 24 is a diagram illustrating a state that the image shown in Fig. 18 has been subjected to processing for division into solar battery cells 100. Fig. 24 shows that solar battery cell 100 in the second row from the top and in the fourth column from the left among solar battery cells 100 constituting solar battery module 120 corresponds to pattern mode "A1". Fig. 25 shows that solar battery cell 100 corresponding to pattern mode "A1" corresponds to a defective mode "V", that is, cell crack in a high resistance state, because solar battery cell 100 adjacent to solar battery cell 100 corresponding to pattern mode "A1" corresponds to no pattern mode. The high resistance state refers to such a state that a current is less likely to flow. If a crack is generated in a cell in a string of the solar battery module in which a plurality of solar battery cells are connected to one another through interconnectors, a pattern showing such an image is observed.

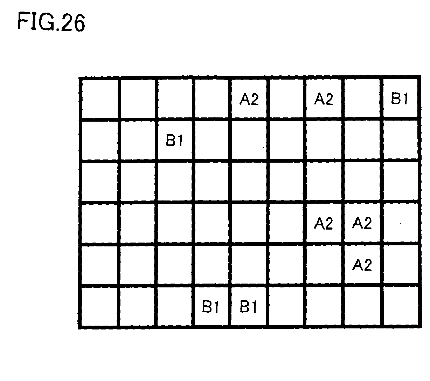

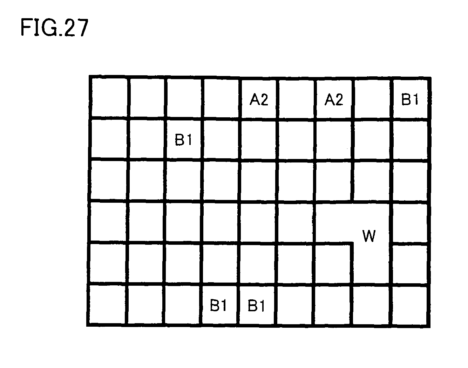

Figs. 26 and 27 are diagrams illustrating a state that the image shown in Fig. 19 has been subjected to processing similar to that described with reference to Figs. 24 and 25. Fig. 26 shows that solar battery cells 100 in the fourth row from the top and in the second and third columns from the right among solar battery cells 100 constituting solar battery module 120 correspond to pattern mode "A2". Fig. 27 shows that solar battery cells 100 corresponding to pattern mode "A2" correspond to a defective mode "W", that is, continuous cell crack, because adjacent solar battery cells 100 correspond to the same pattern mode "A2", which means cluster formation.

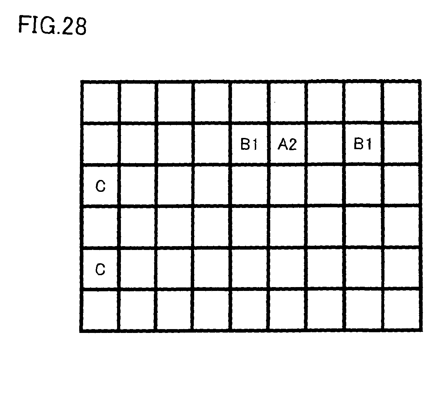

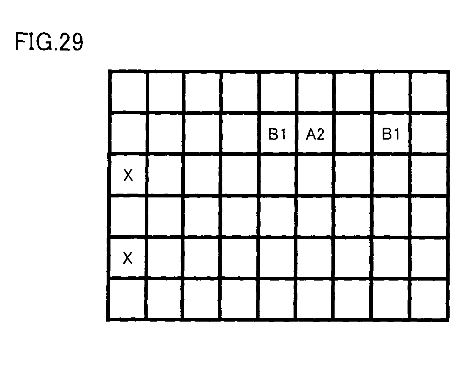

Figs. 28 and 29 are diagrams illustrating a state that the image shown in Fig. 20 has been subjected to processing similar to that described with reference to Figs. 24 and 25. Fig. 28 shows that solar battery cells 100 in the first column from the left and in the third and fifth rows from the top among solar battery cells 100 constituting solar battery module 120 correspond to pattern mode "C". Fig. 29 shows that solar battery cell 100 corresponding to pattern mode "C" corresponds to a defective mode "X", that is, poor connection between solar battery string 110 and the wiring member, because solar battery cell 100 adjacent to solar battery cell 100 corresponding to pattern mode "C" corresponds to no pattern mode.

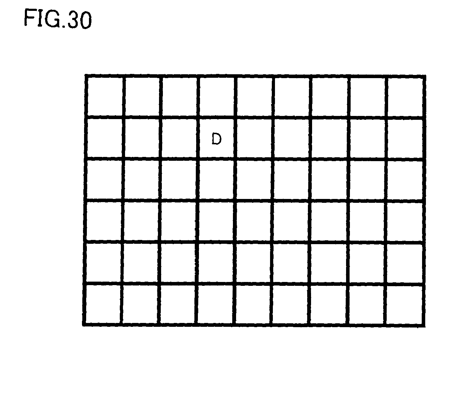

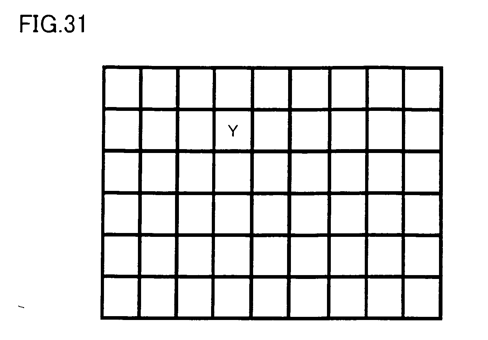

Figs. 30 and 31 are diagrams illustrating a state that the image shown in Fig. 21 has been subjected to processing similar to that described with reference to Figs. 24 and 25. Fig. 30 shows that solar battery cell 100 in the fourth column from the left and in the second row from the top among solar battery cells 100 constituting solar battery module 120 corresponds to pattern mode "D". Fig. 31 shows that solar battery cell 100 corresponding to pattern mode "D" corresponds to a defective mode "Y", that is, short-circuiting (poor insulation) between the positive electrode and the negative electrode of solar battery cell 100, because solar battery cell 100 adjacent to solar battery cell 100 corresponding to pattern mode "D" corresponds to no pattern mode.

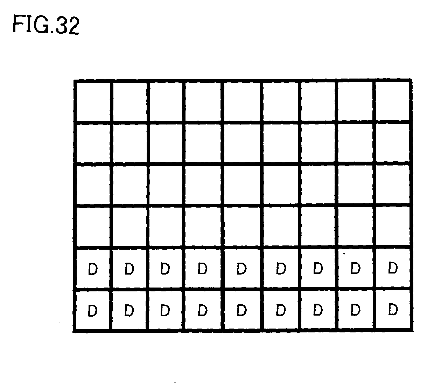

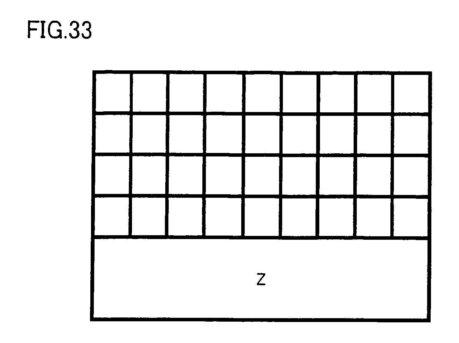

Figs. 32 and 33 are diagrams illustrating a state that the image shown in Fig. 22 has been subjected to processing similar to that described with reference to Figs. 24 and 25. Fig. 32 shows that solar battery cells 100 in the two rows at the bottom among solar battery cells 100 constituting solar battery module 120 correspond to pattern mode "D". Fig. 33 shows that solar battery cells 100 corresponding to pattern mode "D" correspond to a defective mode "Z", that is, reverse connection of solar battery string 110 or short-circuiting of bypass diode 130, because the same pattern mode is observed for each string, which means cluster formation. It is thus very effective in data analysis or in managing change of state over time to accumulate pattern mode information as history information.

In step S226, communication device 508 operating as evaluation unit 19 transfers feedback data to an apparatus performing the step that resulted in a defect under the control of CPU 500 similarly operating as evaluation unit 19. In the present embodiment, the "feedback data" refers to data of the defective mode. Instead of transferring the feedback data, display 501 and interface 509 operating as evaluation unit 19 may output feedback data to an operator or a manager performing the step that resulted in a defect. After these processes, contents in at least one step among the steps from step S 100 to step S 112 described above are changed in accordance with contents in the result of evaluation by evaluation unit 19, that is, the feedback data. Change in the contents in the step may be made automatically by an apparatus responsible for each step from step S 100 to step S 112 described above or manually by the manager of these apparatuses.

As described above, the solar battery module evaluation apparatus according to the first embodiment of the present invention can quickly specify well a defect caused in the process of manufacturing the module of solar battery cells and a cause thereof by analyzing an optical image picked up by the camera. This is because the optical image that appears as a result of supply of energy to the solar battery module well reflects the defect caused in the process of manufacturing the module of solar battery cells and the cause thereof.

When the defect caused in the process of manufacturing the module of solar battery cells and the cause thereof are quickly specified, the solar battery module evaluation apparatus according to the present embodiment can transfer the feedback data to the apparatus that has caused the defect or notify the operator or the manager of the apparatus of that fact. Management of the process of manufacturing the solar battery module connected through the interconnectors can thus be facilitated. In addition, feedback control of manufacturing of the solar battery module can be carried out. As feedback control can be carried out, the solar battery module capable of maintaining high electric power generation efficiency can efficiently be manufactured.

As such, solar battery modules capable of maintaining high electric power generation efficiency can be mass-produced in a stable manner. In addition, by constructing a solar power generation system with such solar battery modules, a solar power generation system capable of maintaining high electric power generation efficiency can be produced at low cost. As such solar power generation systems are produced at low cost, initial investment in the solar power generation system or maintenance cost can soon be recovered. Early recovery of initial investment or maintenance cost accelerates further widespread use of the solar power generation system. Consequently, a solar battery module evaluation apparatus, a solar battery module evaluation method, and a solar battery module manufacturing method capable of accelerating further widespread use of the solar power generation system can be provided.

In addition, as the solar battery module evaluation apparatus according to the present embodiment can determine a direction of a solar battery cell by recognizing shade of the electrode pattern, a defective solar battery cell can be specified based on accurate coordinate information.

The solar battery module evaluation apparatus according to a first variation of the present embodiment may be an apparatus evaluating a solar battery module including solar battery cells formed from a single crystal or amorphous silicon flat plate.

Alternatively, a solar battery module evaluation apparatus according to a second variation of the present embodiment may include an apparatus supplying energy to solar battery module 120 instead of power supply unit 11 described above. This solar battery module evaluation apparatus may include an apparatus supplying energy to solar battery module 120 in addition to power supply unit 11 described above. Examples of the form of energy to be supplied include light. Camera 12 can thus pick up an optical image that appears from solar battery cell 100 through photoluminescence phenomenon.

Alternatively, a solar battery module evaluation apparatus according to a third variation of the present embodiment may include an apparatus supplying electric power other than electric power for light emission through electroluminescence phenomenon, instead of power supply unit 11 described above.

Alternatively, a solar battery module evaluation apparatus according to a fourth variation of the present embodiment may include an operation unit instead of pattern storage unit 17 and comparison unit 18. Here, the operation unit performs an operation on data of a portion of which pattern has been recognized by recognition unit 16, in the image picked up by camera 12. Such an operation includes processing for calculating an average value of lightness of a pixel constituting the portion of which pattern has been recognized by recognition unit 16 or processing for calculating standard deviation of such lightness. Here, the solar battery module evaluation apparatus includes, instead of evaluation unit 19, an apparatus outputting information corresponding to a result of operation by the operation unit, out of pattern information indicating whether solar battery module 120 is defective or not. The information output by this apparatus includes information indicating whether the average value of lightness is equal to or greater than a threshold value and information indicating whether standard deviation of lightness is equal to or greater than a threshold value. The processing unit of the solar battery module evaluation apparatus serves here again as an apparatus outputting pattern information indicating whether solar battery module 120 is defective or not, based on data of the image picked up by camera 12, the image being an optical image that appears as a result of supply of electric power to solar battery module 120.

Alternatively, a recognition unit in a solar battery module evaluation apparatus according to a fifth variation of the present embodiment may recognize solar battery string 110 instead of solar battery cell 100 in step S206. Thus, a processing unit of the solar battery module evaluation apparatus according to the fifth variation of the present embodiment operates as an apparatus outputting pattern information indicating whether solar battery module 120 is defective or not, based on data of the optical image of one solar battery string 110 that appears as a result of supply of electric power.

Alternatively, a processing unit in a solar battery module evaluation apparatus according to a sixth variation of the present embodiment may not include result storage unit 20. Here, pattern information indicating whether solar battery module 120 is defective or not and data necessary for notifying as feedback the manufacturing apparatus of solar battery module 120 of defect are presented to an operator on display 501 or through warning light 602 or the like.

Alternatively, in a seventh variation of the present embodiment, processing in at least one step among steps from step S 100 to step S1124 may manually be performed by an operator.

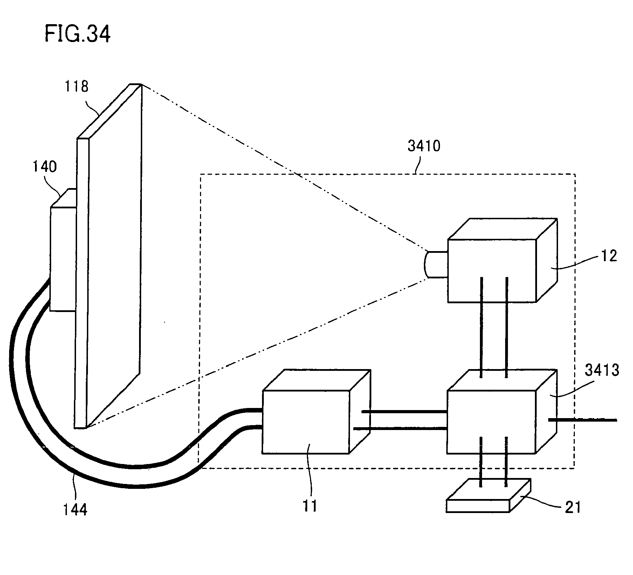

Fig. 34 is a configuration diagram showing a solar battery module evaluation apparatus 3410 according to a second embodiment of the present invention.

Solar battery module evaluation apparatus 3410 includes power supply unit 11 supplying electric power by applying a forward bias voltage to a lead of a solar battery module in process 118, camera 12 picking up an optical image that appears as a result of supply of electric power, and a processing unit 3413 performing pattern recognition of the image picked up by camera 12 based on data of that image and outputting pattern information indicating whether solar battery module in process 118 is defective or not to warning light 602 or the like which will be described later. In inspecting solar battery module in process 118, a connector 140 forming a part of power supply unit 11 is connected to the lead of solar battery module in process 118. Connector 140 is connected to a main body of power supply unit 11 through a cable 144 forming a part of power supply unit 11. In the present embodiment, power supply unit 11 supplies energy to a solar battery of a flat panel type made of silicon. As power supply unit 11 supplies electric power, solar battery cell 100 constituting solar battery module in process 118 emits light through electroluminescence phenomenon.

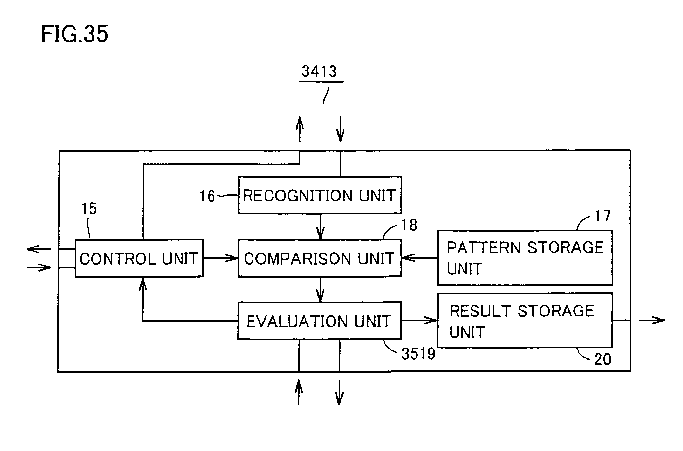

Fig. 35 is a control block diagram of processing unit 3413. Referring to Fig. 35, processing unit 3413 includes control unit 15 controlling power supply unit 11, camera 12 and processing unit 3413 itself, recognition unit 16 performing pattern recognition of a shape of solar battery cell 100 based on the data of the image picked up by camera 12, pattern storage unit 17 storing data of a reference pattern in advance, comparison unit 18 comparing a portion of which pattern has been recognized by recognition unit 16 in the image picked up by camera 12 with the reference pattern, and an evaluation unit 3519 outputting pattern information indicating whether solar battery module in process 118 is defective or not. In the present embodiment, the "reference pattern" refers to an optical image that appears as a result of supply of electric power to a defective solar battery module.

In the present embodiment, processing unit 3413 includes result storage unit 20 storing pattern information indicating whether solar battery module in process 118 is defective or not. Result storage unit 20 includes a data extraction unit extracting data necessary for providing feedback that the solar battery module is defective to an apparatus for manufacturing a solar battery module, and a data transmission unit transmitting extracted data to an external apparatus.

Processing unit 3413 is preferably connected to external memory 21. External memory 21 is a device storing information output from evaluation unit 3519. When data of a process management sheet is stored in external memory 21 and such external memory 21 is provided for each solar battery module in process 118, a module ID number may also be stored in external memory 21. If the module ID number is stored in advance in external memory 21, processing unit 3413 preferably can recognize the module ID number.

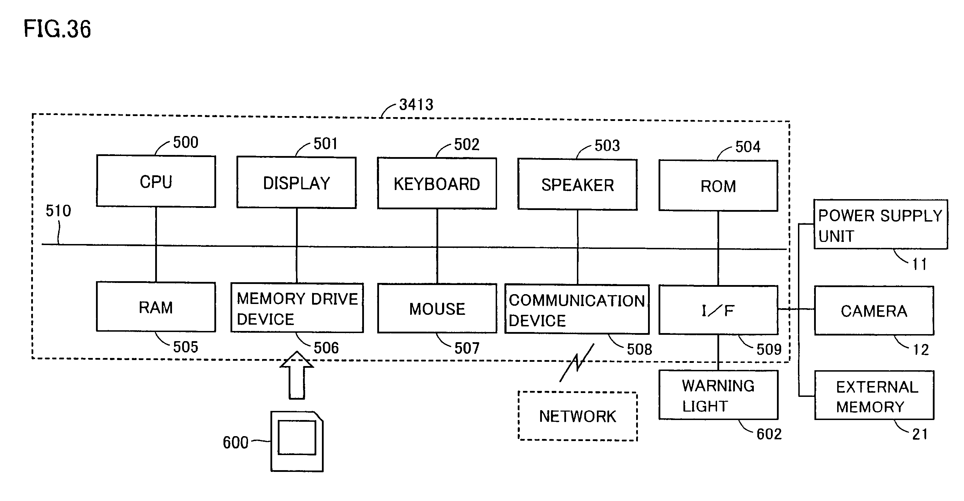

Fig. 36 is a control block diagram of computer hardware implementing processing unit 3413. In the present embodiment, each unit constituting processing unit 3413 is a virtual circuit implemented by computer hardware shown in Fig. 36. The computer shown in Fig. 3 6 has a configuration similar to the computer shown in Fig. 3. The functions implemented by this configuration are also the same. Therefore, description of the computer hardware will not be repeated here.

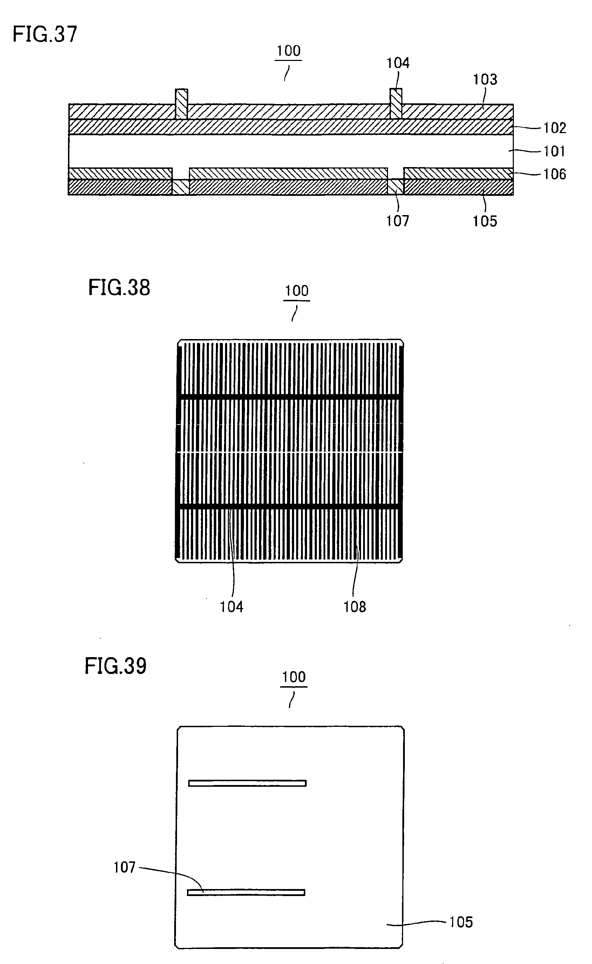

Fig. 37 is a schematic cross-sectional view of solar battery cell 100 according to the present embodiment. Solar battery cell 100 used in the present embodiment will be described with reference to Fig. 37.

In the present embodiment, solar battery cell 100 is formed of a polycrystalline silicon substrate of 155mm square and a thickness of 200µm. A pn junction is formed by forming n+ layer 102 on a light-receiving surface of p-type silicon substrate 101. Anti-reflection coating 103, bus bar electrode 104, and finger electrode 108 which will be described later are formed on a surface of n+ layer 102. P+ layer 106 is formed on a back surface opposite to the light-receiving surface of p-type silicon substrate 101. Aluminum electrode 105 and silver electrode 107 are formed on the back surface of p-type silicon substrate 101.

Though not necessarily essential, in the present embodiment, a surface of bus bar electrode 104 and a surface of silver electrode 107 are coated with a solder. A solder coating method includes a method of immersing bus bar electrode 104 and silver electrode 107 in a molten solder bath.

After solar battery cell 100 is manufactured, a current-voltage characteristic (IV characteristic) of solar battery cell 100 is determined. In order to determine the IV characteristic, a solar simulator is used to irradiate solar battery cell 100 with simulated solar rays. After the IV characteristic is determined, only a solar battery cell satisfying prescribed conversion efficiency among solar battery cells 100 is supplied to a module step.

Fig. 38 is a diagram showing a pattern of bus bar electrode 104 and finger electrode 108. In the present embodiment, bus bar electrode 104 and finger electrode 108 are formed on the light-receiving surface of p-type silicon substrate 101. Bus bar electrode 104 is implemented by an electrode having a relatively large width and a linear shape and made of silver. Finger electrode 108 is implemented by a plurality of electrodes that extend from bus bar electrode 104, have a relatively small width and a linear shape, and are made of silver. In solar battery cell 100 according to the present embodiment, two bus bar electrodes 104 are formed on the light-receiving surface. A plurality of finger electrodes 108 extending from each bus bar electrode 104 are separated at the center of the cell.

Fig. 39 is a diagram showing a pattern of aluminum electrode 105 and rectangular silver electrode 107 formed on the back surface of p-type silicon substrate 101. Silver electrode 107 is arranged in line with arrangement of bus bar electrode 104 such that it is located closer to one side with respect to the center of solar battery cell 100. The reason why silver electrode 107 is provided in addition to aluminum electrode 105 is because it is difficult to coat aluminum electrode 105 with the solder and silver electrode 107 readily coated with the solder is necessary.

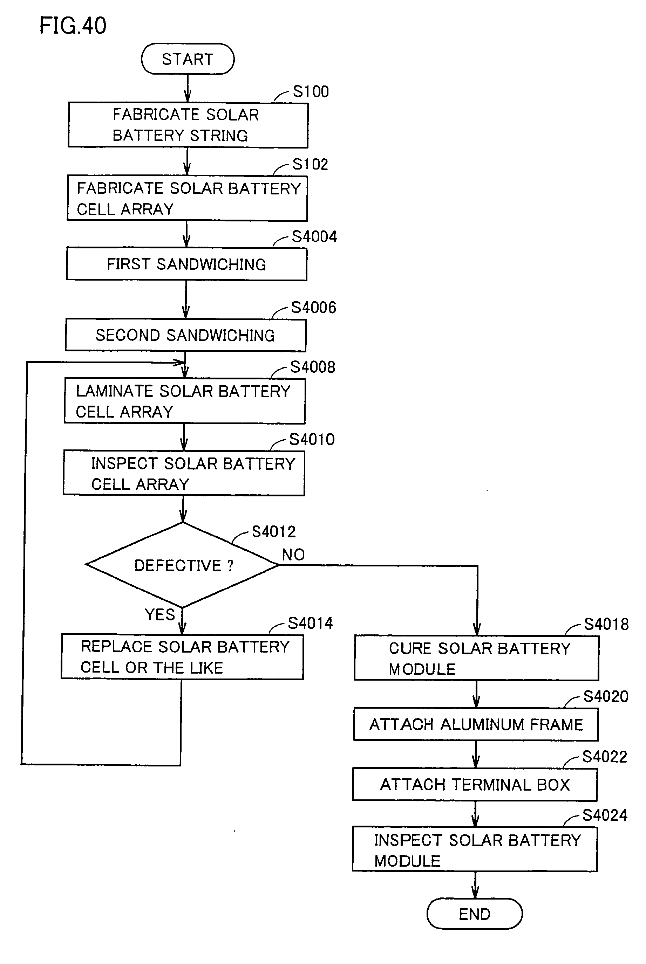

An exemplary method of manufacturing a solar battery module with solar battery cells 100 is shown with reference to Figs. 40 to 53. Fig. 40 is a flowchart showing a procedure for manufacturing a solar battery module.

In step S100, the manufacturing apparatus connects one end of interconnector 109 implemented by a conductive member to bus bar electrode 104 of solar battery cell 100 and connects the other end thereof to silver electrode 107 of another solar battery cell 100.

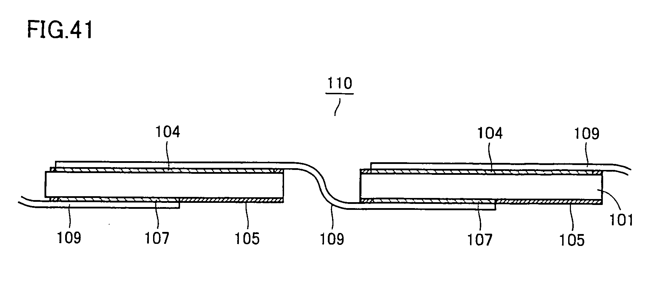

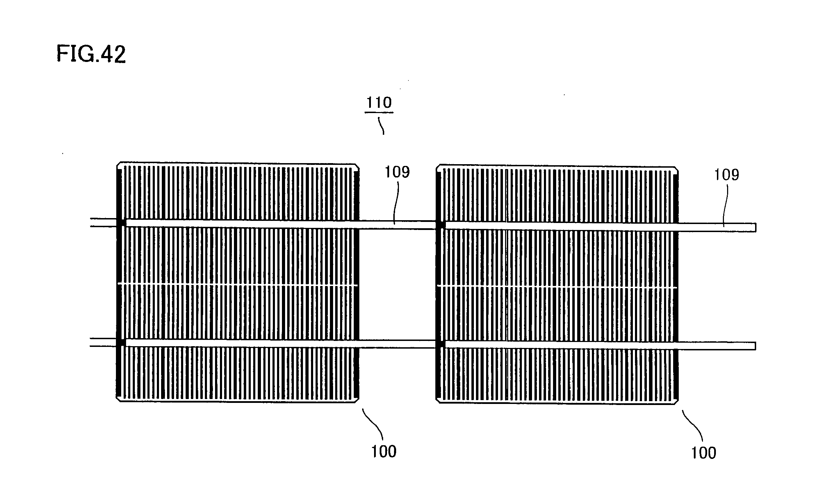

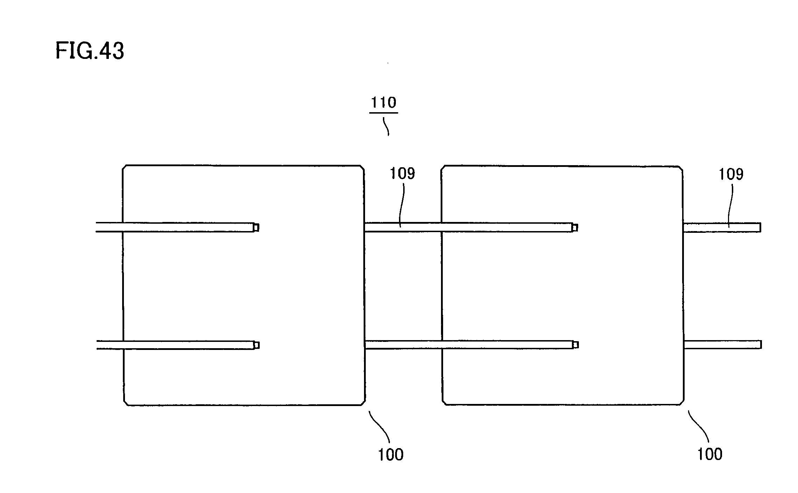

Fig. 41 is a schematic cross-sectional view of solar battery string 110 in which solar battery cells 100 are connected in series. As can clearly be seen from Fig. 41, interconnector 109 fixed to bus bar electrode 104 on the light-receiving surface of solar battery cell 100 by means of solder or the like is also fixed to silver electrode 107 of adjacent solar battery cell 100 by means of solder or the like. It is noted that n+ layer 102 and p+ layer 106 are not shown in Fig. 41. In the present embodiment, interconnector 109 is implemented by a conductive member (copper wire) plated with solder. Interconnector 109 and two solar battery cells 100 are connected to each other through heating of bus bar electrode 104 of one solar battery cell 100, silver electrode 107 of another solar battery cell 100, and interconnector 109 while interconnector 109 lies on bus bar electrode 104 and silver electrode 107. Solar battery cells 100 are thus connected in series through the conductive member, to thereby fabricate solar battery string 110. Fig. 42 is a plan view of a part of solar battery string 110 when viewed from a light-receiving surface side. Fig. 43 is a plan view of a part of solar battery string 110 when viewed from the back surface side. As can clearly be seen from Figs. 42 and 43, in the present embodiment, interconnector 109 on the light-receiving surface side is connected to bus bar electrode 104 across solar battery cell 100 from one end to the other end, and interconnector 109 on the side opposite to the light-receiving surface is connected to silver electrode 107 across an area from one end to the vicinity of the center of the back surface of solar battery cell 100.

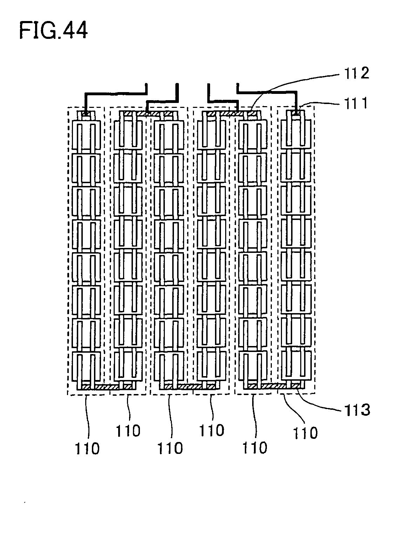

Referring again to Fig. 40, in step S 102, the manufacturing apparatus arranges solar battery strings 110 and connects in series interconnectors 109 projecting from opposing ends of solar battery string 110 to interconnectors 109 projecting from opposing ends of another solar battery string 110, by using wiring member 111, wiring member 112 and wiring member 113 implemented by a conductive member. A method for connecting interconnector 109 is not particularly limited. For example, the method may be soldering. Here, bypass diode 130 which will be described later may also be attached. Through this step, a plurality of solar battery strings 110 are formed as solar battery cell array 123. Fig. 44 is a diagram schematically showing arrangement of solar battery strings 110 and a connection state of wiring member 111, wiring member 112, and wiring member 113 in solar battery cell array 123.

Referring again to Fig. 40, in step S4004, the manufacturing apparatus sandwiches solar battery cell array 123 between EVA (Ethylene Vinyl acetate) film 122 and EVA film 124 serving as an enclosing material. For example, solar battery cell array 123 is sandwiched by sequentially layering EVA film 122, solar battery cell array 123, and EVA film 124 on glass plate 121 on the light-receiving surface side.

In step S4006, the manufacturing apparatus sandwiches solar battery cell array 123 sandwiched between EVA film 122 and EVA film 124, between glass plate 121 and back film 125. For example, back film 125 is placed on EVA film 124 such that the lead forming a part of wiring member 111 and the lead forming a part of wiring member 112 are drawn out of a not-shown hole in back film 125.

In step S4008, the manufacturing apparatus removes air bubbles introduced between EVA film 122 and EVA film 124 through pressure reduction, and heats solar battery cell array 123 sandwiched between glass plate 121, EVA film 122, EVA film 124, and back film 125 for lamination. A temperature for heating is approximately in a range from 393K to 403K. EVA film 122 and EVA film 124 are pressed and adhered to each other in this step, so that solar battery string 110 is enclosed with EVA in a positioned state. Solar battery module in process 118 is thus fabricated. At this temperature, EVA film 122 and EVA film 124 are pressed and adhered to each other in a fused state, however, this temperature does not allow sufficient crosslinking reaction. Accordingly, back film 125 pressed and adhered to EVA film 124 can easily be removed. In addition, back film 125 can also partially be removed. When replacement is necessary, after back film 125 is peeled off, the solar battery cell or the solar battery string sandwiched between EVA film 122 and EVA film 124 is removed together with the EVA films and replaced with a normal one. In replacement, EVA film 122 on the glass plate 121 side and EVA film 124 on the back film 125 side are preferably both replaced, and separation of interconnector 109 or the like connected to an electrode of a defective cell or the like and reconnection of a new non-defective cell or the like is performed as appropriate. A new good cell or the like sandwiched between the EVA films is covered again with back film 125 and lamination is performed again.

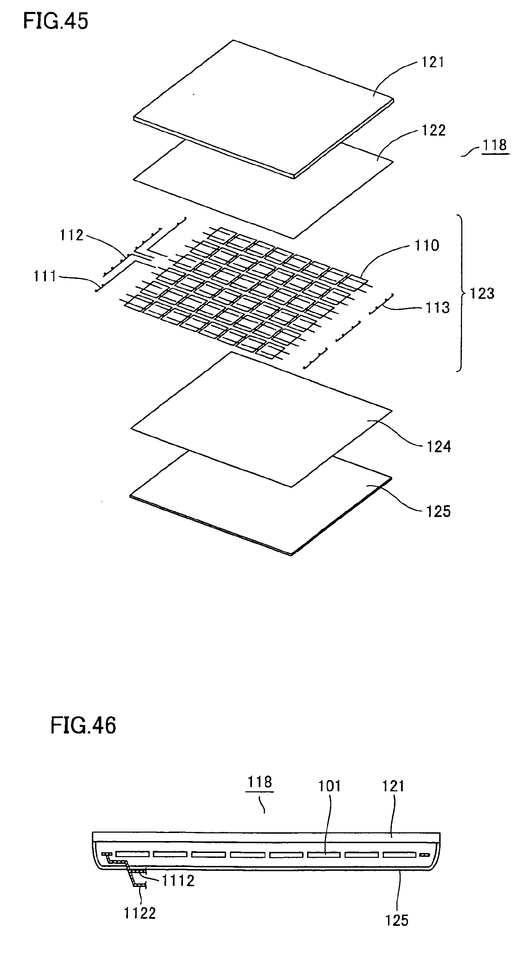

Fig. 45 is a diagram illustrating a structure of solar battery module in process 118 and shows an exploded perspective view with a light-receiving surface facing upward. Fig. 46 is a cross-sectional view of solar battery module in process 118 after lamination.

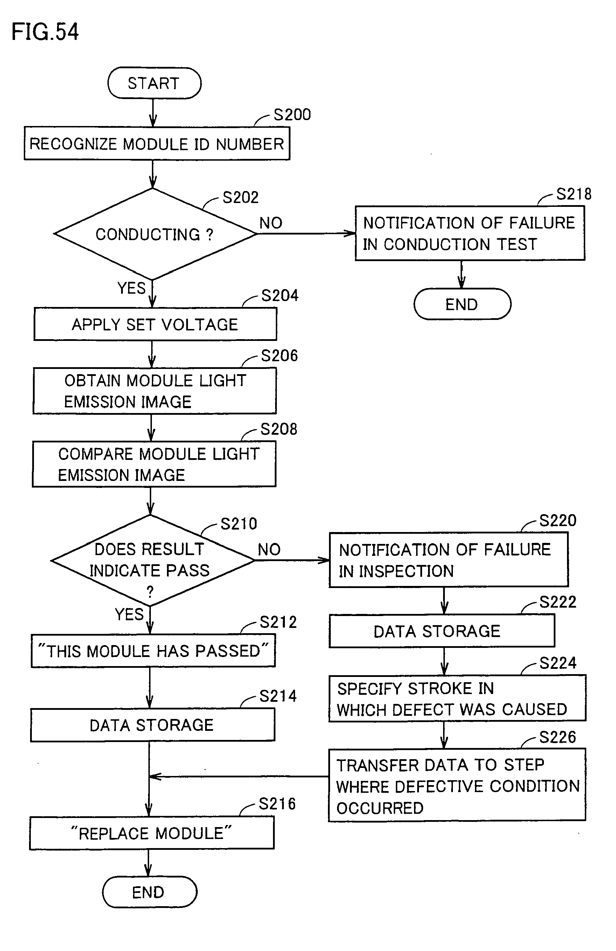

Referring again to Fig. 40, in step S4010, the manufacturing apparatus holds solar battery module in process 118 in a position easy for solar battery module evaluation apparatus 3410 to perform inspection. Solar battery module evaluation apparatus 3410 connects connector 140 to a lead 1112 and a lead 1114 as well as a lead 1122 and a lead 1124. Lead 1112 and lead 1114 are leads for wiring member 111. Lead 1122 and lead 1124 are leads for wiring member 112. Thus, electric energy can be supplied to a portion of these leads where a conductor is exposed. It is noted that the portion where the conductor is exposed is referred to as an "exposed portion" in this step. As can clearly be seen from Fig. 44, in the present embodiment, a group of solar battery strings 110 is divided by the leads attached to wiring member 111 and the leads attached to wiring member 112 so that electric power can be supplied for each group of solar battery strings 110. Since the group of solar battery strings 110 is divided as such, electric power can be supplied through these leads to each set of solar battery cells 100 divided by these leads, by supplying electric energy to the exposed portion of these leads. Any method may be adopted as the method of connecting connector 140 to the exposed portion, so long as electric power can be supplied. For example, connector 140 may be pressed against the exposed portion. Alternatively, solar battery module in process 118 may be placed on connector 140 fixed to solar battery module evaluation apparatus 3410 and the exposed portion may be pressed against under the weight of solar battery module in process 118 itself. Alternatively, connector 140 and the exposed portion may be connected to each other by a clip or the like. In the present embodiment, connector 140 is pressed against the exposed portion. When connector 140 is connected, solar battery module evaluation apparatus 3410 inspects solar battery module in process 118. Each processing in this inspection corresponds to processing from step S200 to step S226 shown in the flowchart in Fig. 54 which will be described later. When the inspection ends, solar battery module evaluation apparatus 3410 transmits information on the result of inspection to the manufacturing apparatus, separately from feedback data which will be described later.

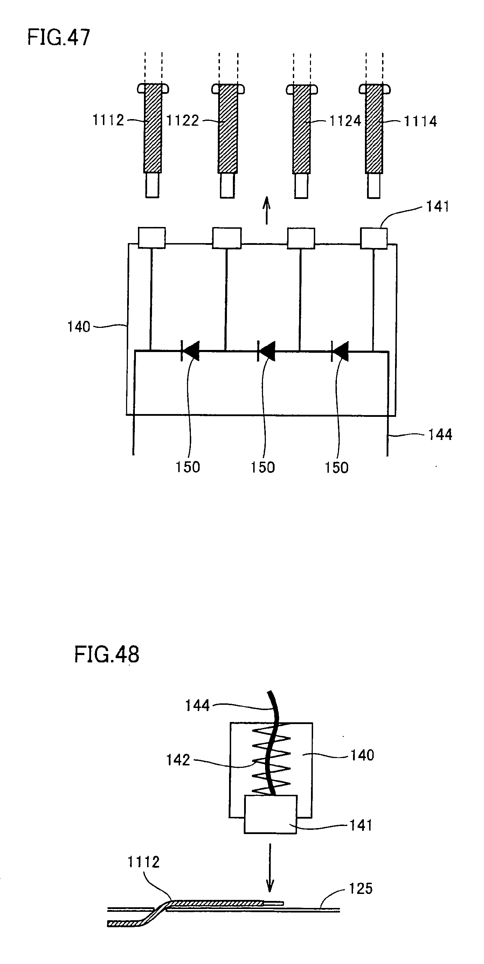

Referring to Figs. 47 and 48, connector 140 will be described. Fig. 47 is a diagram illustrating wiring in connector 140. Fig. 48 is an exemplary conceptual diagram illustrating a mechanical structure of connector 140 and a conceptual diagram of connector 140 shown in Fig. 47 when viewed from the side. In the present embodiment, connector 40 includes four terminals 141, four springs 142 attached to terminals 141 respectively, and three bypass diodes 150 connected between four terminals 141 respectively and connected in series. Four terminals 141 come in contact with lead 1112, lead 1122, lead 1124, and lead 1114, respectively, and supply electric power thereto. Springs 142 presses terminals 141 against lead 1112, lead 1122, lead 1124, and lead 1114, respectively. Bypass diode 150 distributes electric power to each terminal 141. A voltage across opposing ends of three bypass diodes 150 connected in series is set by the main body of power supply unit 11.

Referring again to Fig. 40, in step S4012, the manufacturing apparatus determines whether solar battery module in process 118 inspected in step S4010 is defective or not, based on the information on the result of inspection received in step S4010. If solar battery module in process 118 is determined as defective (YES in step S4012), the process proceeds to step S4014. Otherwise (NO in step S4012), the process proceeds to step S4018.

If the solar battery module has been determined as defective in step S4012, the manufacturing apparatus turns on in step S4014 an indicator indicating that solar battery module in process 118 has been determined as defective. The manufacturing apparatus places solar battery module in process 118 determined as defective on a not-shown tray for repair. When solar battery module in process 118 is placed, an operator peels off back film 125 pressed and adhered to EVA film 124 of solar battery module in process 118 so that EVA film 124 is exposed. Then, the operator replaces solar battery string 110 including solar battery cell 100 determined as defective with new solar battery string 110, based on the information on the result of inspection displayed on a display apparatus or the like and received in step S4010. If certain solar battery cell 100 alone has been determined as defective, the operator may replace only that solar battery cell 100 with new solar battery cell 100.

Here, the operator makes up a portion peeled off in step S4014, together with EVA film 122 and EVA film 124, and replaces back film 125 as appropriate.

If the solar battery module has been determined as non-defective in step S4012, the manufacturing apparatus heats solar battery module in process 118 to a temperature approximately from 413K to 423K in step S4018. In this step, EVA film 122 and EVA film 124 are cured through sufficient crosslinking reaction, so that enclosing of solar battery cell array 123 with EVA is completed. Thus, the step of crosslinking EVA by heating solar battery module in process 118 such that an enclosing material is crosslinked to an extent sufficient as a product is referred to as a "curing step". When this step is completed, a solar battery module after the curing step is fabricated.

An example in which the operator performs a replacement operation is described here, however, a series of operations may be performed by the manufacturing apparatus based on the information on the result of inspection received in step S4010.

In step S4020, the manufacturing apparatus attaches aluminum frame 1262 and aluminum frame 1264 to the solar battery module after the curing step.

In step S4022, the manufacturing apparatus attaches terminal box 127 provided with cable 128 to the solar battery module after the curing step, to which aluminum frame 1262 and aluminum frame 1264 have been attached. Here, female terminal 1292 and male terminal 1294 implementing the electric power output terminals are electrically connected to the leads connected to wiring member 111 and wiring member 112. Completed solar battery module 120 is thus fabricated.

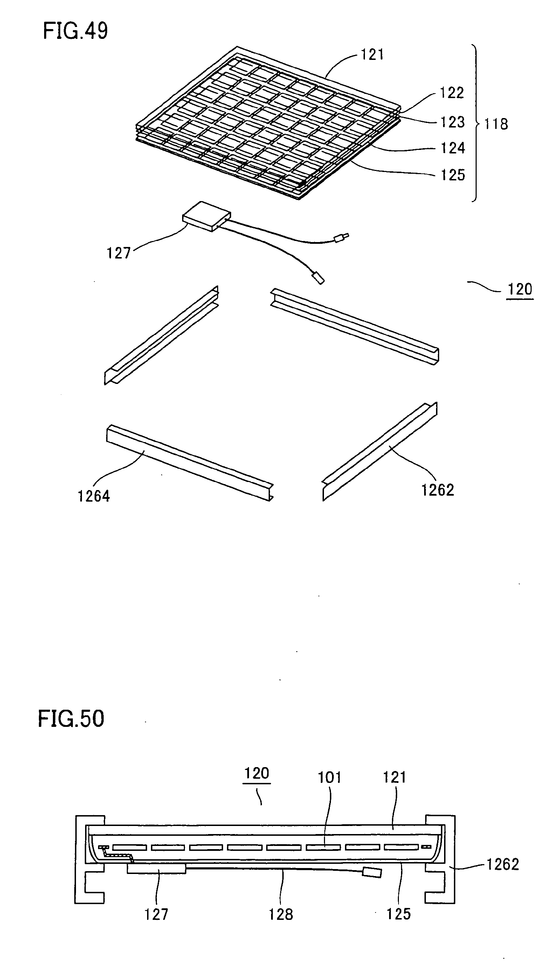

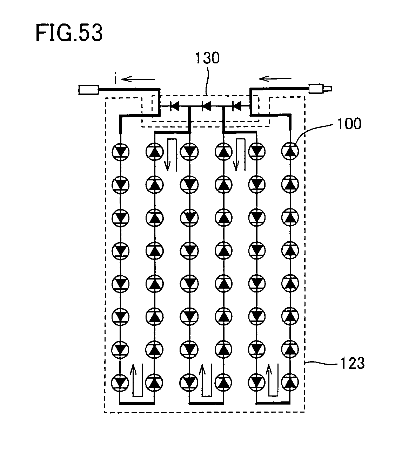

Fig. 49 is a diagram illustrating a structure of completed solar battery module 120. Fig. 50 is a cross-sectional view of completed solar battery module 120. It is noted that interconnector 109, wiring in terminal box 127 and the like are not shown in Fig. 50. As shown in Fig. 53 which will be described later, however, terminal box 127 preferably includes bypass diode 130.

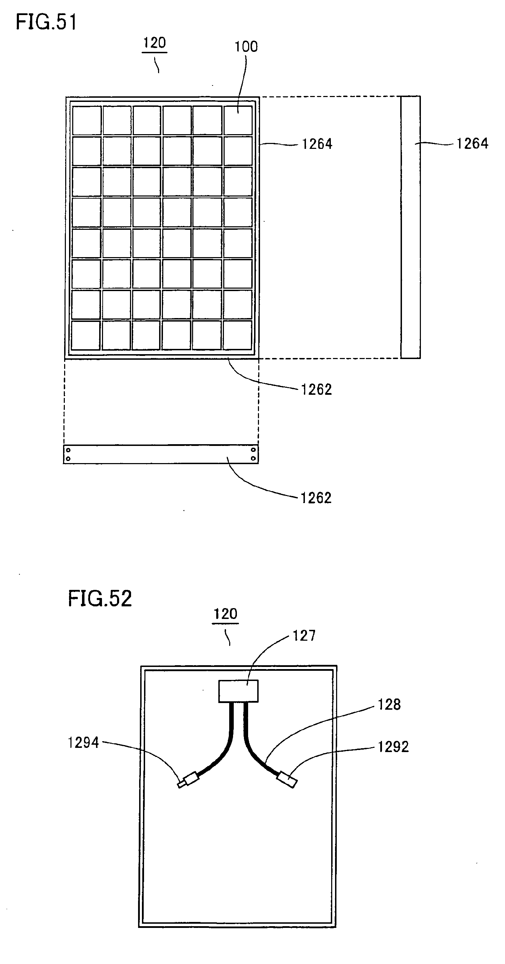

Fig. 51 is a diagram illustrating completed solar battery module 120 with a third angle projection method. In Fig. 51, the plan view, the front view, and the right side view are connected to one another with a dashed line. As shown in Fig. 51, aluminum frame 1262 and aluminum frame 1264 of completed solar battery module 120 are fixed to each other with a screw or the like.

Fig. 52 is a diagram showing a bottom surface of completed solar battery module 120. One ends of two cables 128 are connected to terminal box 127. The other ends of these cables 128 include female terminal 1292 and male terminal 1294 respectively.

Fig. 53 is a diagram showing as a circuit diagram, arrangement of solar battery cells 100 and a connection state of bypass diode 130 in completed solar battery module 120. An arrow in Fig. 53 shows a current flow when electric power generation is normally performed. If a dead leaf or the like partially casts shadow over the light-receiving surface of solar battery cell 100, an amount of electric power generation in that portion is lowered and electric resistance of that solar battery cell 100 becomes greater. As the electric resistance of solar battery cell 100 becomes greater, that solar battery cell 100 blocks the current and generates heat due to resistance loss. In order to avoid blocking of the current or heat generation, completed solar battery module 120 has a bypass diode function for bypassing solar battery cell 100 over which shadow is partially cast. In the present embodiment, three bypass diodes 130 are attached to completed solar battery module 120 as a current path for bypassing solar battery string 110 of which amount of electric power generation has been lowered.

In step S4024, the operator irradiates completed solar battery module 120 with simulated solar rays by using a solar simulator. When the solar battery module is irradiated with the simulated solar rays, the operator inspects the IV characteristic between terminal 1292 and terminal 1294 of completed solar battery module 120. When the IV characteristic is inspected, the operator packs and ships only the solar battery module of which IV characteristic satisfies criteria or sends the same to a production line for producing the solar power generation system.

Fig. 54 is a flowchart showing a procedure for controlling processing for inspecting solar battery module in process 118 by using solar battery module evaluation apparatus 3410. In the present embodiment, the inspection processing is started, for example, by pressing a not-shown inspection start button of solar battery module evaluation apparatus 3410. In addition, if inspection is managed in external memory 21, attachment of external memory 21 to processing unit 3413 may be regarded as trigger for starting inspection. Here, a result of inspection may subsequently be stored in external memory 21, assuming that the module ID number has been recognized based on the fact that attachment of external memory 21 was recognized. A specific procedure in the inspection processing will be described with reference to Fig. 54.

In step S200, the module ID number which is the identification code of solar battery module in process 118 and completed solar battery module 120 is identified. A method for identifying the module ID is not particularly limited. For example, the method includes the following two methods.

The first method is a method in which an image printed or pictographically formed on a light-receiving glass surface and picked up by camera 12 is identified by CPU 500 operating as a device included in recognition unit 16. The second method is a method in which information stored in external memory 21, a bar code, an IC tag, or the like is identified or read by CPU 500 operating as a device included in evaluation unit 3519.

In the present embodiment, it is assumed that the second method is adopted. When camera 12 picks up an image of the module ID number, CPU 500 operating as recognition unit 16 preferably processes the module ID number as directory management information. Here, the module ID number is preferably temporarily stored in RAM 505 operating as recognition unit 16, such that the module ID number is associated with data of an image subsequently picked up by camera 12. Here, when camera 12 picks up an image, data representing that image is stored in association with the data of the module ID number.

On the other hand, when the module ID number is identified based on external information such as information in external memory 21, the module ID number is preferably temporarily stored in RAM 505 operating as evaluation unit 3519. Finally, the module ID number is preferably stored in RAM 505 operating as result storage unit 20 in association with pattern information indicating whether solar battery module in process 118 is defective or not.

In step S202, CPU 500 operating as control unit 15 determines whether solar battery module in process 118 is conducting or not. In the present embodiment, conduction is checked in the following procedure. The first procedure is a procedure in which CPU 500 operating as control unit 15 measures a short-circuit current (Isc) or an open circuit voltage (Voc) of a solar battery with an ammeter or a voltmeter contained in power supply unit 11. The second procedure is a procedure in which these measurement values are checked by control unit 15. When the solar battery module is conducting (YES in step S202), the process proceeds to step S204. Otherwise (NO in step S202), the process proceeds to step S218.

In step S204, CPU 500 operating as control unit 15 issues to power supply unit 11, a command to apply a voltage. Power supply unit 11 applies a prescribed forward bias voltage. Electric power is thus supplied to solar battery cells 100 within solar battery module in process 118 after a plurality of solar battery cells 100 are laminated with the enclosing material, that is, EVA film 122 and EVA film 124, and before they are cured. Electric power is supplied through lead 1112, lead 1114, lead 1122, and lead 1124.

As described above, these leads are drawn out from the enclosing material and connected to interconnector 109. As the electric power supplied in this step is electric power for having solar battery module in process 118 emit light through electroluminescence phenomenon, the voltage and current thereof are adapted to the specifications of solar battery module in process 118. In order to have the voltage and current adapted to the specifications, a current value may be adjusted by sensing a current that flows through solar battery module in process 118 at the time of application of the voltage and controlling a voltage value. In applying the forward bias voltage, the forward bias voltage may be applied in a stepwise fashion, while assuming a pattern mode. When the voltage is applied in a stepwise fashion, the number of steps in increasing the voltage value may be equal to the number of current paths resulting from division by bypass diode 130. When the voltage is applied in a stepwise fashion, in a module having a current path through a bypass diode due to poor connection in the solar battery string, a value of a current that flows through the solar battery cell becomes great under an application condition suited to a normal module. An extreme example is a defective module in which there is only a single set of strings that are normally connected. Thus, an unexpected defect in the inspection step such as poor connection or the like between an interconnector and an electrode caused by flow of excessive current through a normally connected string can be avoided, and recovery of performance can effectively be achieved by repairing the defective string produced in the manufacturing process. In addition, such an event that, though a defect due to excessive current can be avoided in the inspection step, in re-inspection after repair, a string determined as normal in previous inspection subsequently turns out to be defective in the inspection step after repair can be avoided, and production efficiency is improved.

In step S206, camera 12 picks up, as an image, light that appears from a planar portion, that is, the light-receiving surface, of solar battery cell 100 as a result of electric power of the forward bias voltage. Data of the picked-up image is sent to CPU 500 operating as recognition unit 16. In the present embodiment, CPU 500 operating as recognition unit 16 recognizes a portion of solar battery cell 100 in the picked-up image. Processing unit 3413 can thus operate as a device outputting pattern information indicating whether solar battery module in process 118 is defective or not, based on the data of the optical image of one solar battery cell 100 that appears as a result of supply of electric power.

In addition, in the present embodiment, CPU 500 operating as recognition unit 16 recognizes a position of an electrode based on shadow in the picked-up image cast by the electrode constituting solar battery cell 100. Processing unit 3413 can thus output pattern information indicating whether solar battery module in process 118 is defective or not, based on the data of the image including shadow cast by the electrode of solar battery cell 100. When the position of the electrode is recognized, CPU 500 operating as recognition unit 16 recognizes an orientation of solar battery module in process 118 based on the position thereof. This is because, where adjacent solar battery cells 100 are connected to each other through a plurality of interconnectors 109 and connection of one interconnector 109 is poor, from which manufacturing apparatus connecting interconnector 109 the poor connection resulted can be specified if the position of the electrode is recognized.

In addition, as the shape of the electrode on the side opposite to the light-receiving surface is relatively readily characterized, CPU 500 operating as recognition unit 16 according to the present embodiment recognizes the orientation of the solar battery module by recognizing the position of the electrode on the back surface of solar battery cell 100. Processing unit 3413 can thus operate as a device outputting pattern information indicating whether solar battery module in process 118 is defective or not by using the data of the image including shadow of the electrode of solar battery cell 100.

In the present embodiment, in recognizing a portion of solar battery cell 100 or a position of an electrode, CPU 500 operating as recognition unit 16 specifies a coordinate of that portion. In specifying a cause of defect, CPU 500 operating as recognition unit 16 can thus specify the cause of defect by using the coordinate of solar battery cell 100 where the defect was caused.

In step S208, CPU 500 operating as comparison unit 18 compares a pattern of the image identified by CPU 500 operating as recognition unit 16 with the reference pattern. A comparison method is not particularly limited, so long as at least a part of the pattern of the image identified by recognition unit 16 is compared with the reference pattern. For example, the method includes a method of extracting a pattern corresponding to the reference pattern for each solar battery cell 100 or to the reference pattern for each solar battery string 110 and performing coding for each solar battery cell 100 or solar battery string 110, and a method of superimposing a portion corresponding to the reference pattern, in the pattern of the image identified by recognition unit 16. In the present embodiment, it is assumed that the former method is adopted. In the present embodiment, if a score of matching between the pattern of the image identified by recognition unit 16 and any of the reference patterns is not smaller than a threshold value, CPU 500 operating as comparison unit 18 regards these images as matching with each other.

If the latter method is adopted, the pattern may be superimposed for each solar battery cell 100 or for each solar battery string 110. When the latter method is adopted, the reference pattern for each solar battery cell 100 or a set of patterns for respective solar battery cells 100 may be employed as the reference pattern stored in ROM 504 operating as pattern storage unit 17. If the set of patterns for respective solar battery cells 100 is employed as the reference pattern stored in pattern storage unit 17, the reference pattern is preferably such a pattern that the patterns for respective solar battery cells 100 are aligned in a longitudinal direction of solar battery string 110. If such a pattern that the patterns for respective solar battery cells 100 are aligned in a longitudinal direction of solar battery string 110 is employed as the reference pattern stored in pattern storage unit 17, the number of aligned patterns for respective solar battery cells 100 is equal to the number of solar battery cells 100 constituting solar battery string 110.

In step S210, CPU 500 operating as evaluation unit 3519 specifies whether there is a defective portion in solar battery module in process 118 or not by using a result of pattern comparison obtained in step S208. If there is a defective portion, CPU 500 operating as evaluation unit 3519 specifies a defective portion and also a cause of defect.

The following modes are possible as pattern modes representing types of defect caused in solar battery module in process 118. Pattern mode "A1" and pattern mode "A2" indicate crack of solar battery cell 100. Pattern mode "B" indicates such a defect that finger electrode 108 closer to the center of solar battery cell 100 lying across bus bar electrode 104 is open. Pattern mode "C" indicates poor connection of wiring member 111, wiring member 112 or wiring member 113 with interconnector 109. Pattern mode "D" indicates short-circuiting between the electrodes of solar battery cell 100. Pattern mode "E" indicates reverse connection of solar battery string 110, short-circuiting of bypass diode 130, or open of solar battery cell 100. Relation between these pattern modes and causes thereof is considered as follows.

Cause I is stress in the enclosing step for fabricating a solar battery module, which causes crack in solar battery cell 100.

Cause II is deterioration in the shape of a printing pattern, a trouble in squeegeeing control, or shortage in an amount of silver paste in the step of forming an electrode of solar battery cell 100 (the step of printing silver paste with screen printing or the like), which causes open of bus bar electrode 104 and finger electrode 108 or insufficient width of an electric wire of finger electrode 108 (that is, a phenomenon in which a resistance of the electric wire of finger electrode 108 exceeds a tolerable value).

Cause III is poor soldering between wiring member 111, wiring member 112 or wiring member 113 and interconnector 109, which is caused in the step of soldering wiring member 111, wiring member 112 and wiring member 113 implemented by a conductive member to interconnectors 109 projecting from opposing ends of solar battery string 110 and interconnectors 109 projecting from opposing ends of another solar battery string 110. The soldering step is a part of the step of connecting wiring member 111, wiring member 112 or wiring member 113 to solar battery string 110. Such poor soldering causes a phenomenon in which only a half plane of solar battery cell 100 connected to one bus bar electrode 104 generates electric power.

Cause IV is wrap-around of a wafer edge by the solder in the step of fabricating solar battery string 110, which causes short-circuiting between the electrode on the light-receiving surface and the electrode on the back surface.

Cause V-1 is incorrect setting of solar battery string 110 (connection of solar battery string 110 in a direction reverse to a correct direction), which is caused in the step of soldering wiring member 111, wiring member 112 and wiring member 113 implemented by a conductive member to interconnectors 109 projecting from opposing ends of solar battery string 110 and interconnectors 109 projecting from opposing ends of another solar battery string 110.

Cause V-2 is short-circuiting of bypass diode 130.

Cause V-3 is non-conduction such as disconnection of interconnector 109 connected to one solar battery cell 100, which causes a phenomenon that electric power from a plurality of solar battery strings 110 is not output.

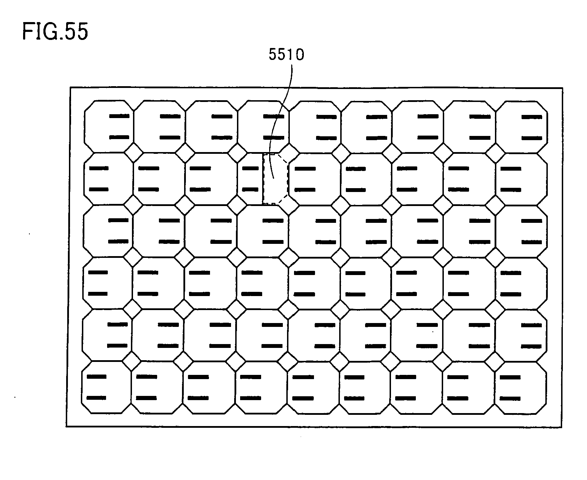

Figs. 55 to 59 show exemplary images obtained by camera 12.

Fig. 55 illustrates a first exemplary image when a defect is caused. In the present embodiment, a defect 5510 shown in Fig. 55 is categorized into pattern mode "A1".

A crack shown in Fig. 55 extends in a direction intersecting interconnector 109. A back surface electrode and a light-receiving surface electrode located on the left-half plane with respect to the center of solar battery cell 100 are connected to adjacent solar battery cells 100 through interconnectors 109 respectively. It seems that electric power generation in this solar battery cell 100 is performed in the left half in Fig. 55 and the right half does not contribute to electric power generation. Therefore, in inspection, light emission from the left-half plane is more intense than that from surrounding solar battery cells 100 and the right-half plane does not emit light. In such a state, even though the output characteristic immediately after manufacturing satisfies prescribed criteria, cracked solar battery cell 100 generates heat as a resistor. When the light emission intensity of solar battery cell 100 in which cell crack corresponding to pattern mode "A1" or pattern mode "A2" occurred is partially greater than that of surrounding cells, it supports the fact that cracked solar battery cell 100 generates heat during electric power generation. If cracked solar battery cell 100 generates heat as a resistor, a connection point of interconnectors 109, EVA film 122, EVA film 124, or the like may suffer from deterioration over time. In that event, output of the solar battery module as a whole may lower due to lowering in the output of solar battery string 110, which is not preferable.

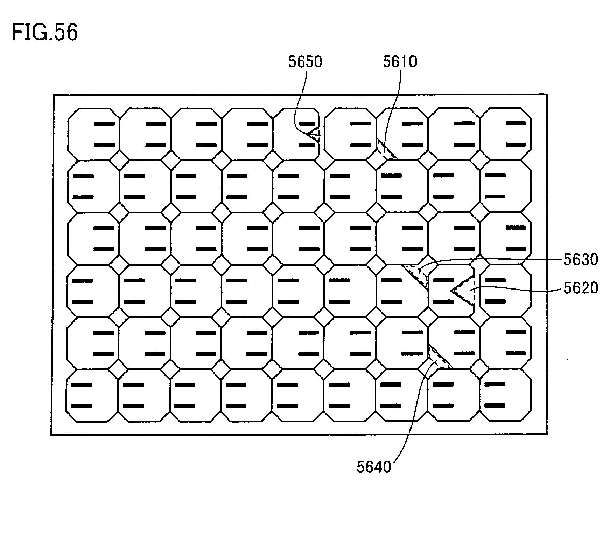

Fig. 56 illustrates a second exemplary image when a defect is caused. In the present embodiment, in solar battery cells 100 shown in Fig. 56, a defect 5610 and a defect 5650 in the third and fifth columns from the right and in the first row from the top respectively, a defect 5620 and a defect 5630 in the second and third columns from the right and in the fourth row from the top respectively, and a defect 5640 in the second column from the right and in the fifth row from the top are categorized into pattern mode "A2".

A cell crack corresponding to pattern mode "A2" refers to such a state that solar battery cell 100 cracks in a direction parallel to interconnector 109 or such a state that the solar battery cell cracks diagonally to interconnector 109. When the cell crack corresponding to pattern mode "A2" is caused, an amount of electric power generation of solar battery cell 100 lowers. Adjacent solar battery cells 100 identical in the pattern mode indicate that solar battery cells 100 have cracked due to local stress in enclosing solar battery cell array 123. By thus analyzing arrangement of the pattern mode, the step causing a defect may be specified.

In the present embodiment, defects in the cell in the first row from the top and in the rightmost column, in the cell in the second row from the top and in the third column from the left, and in the cells in the first row from the bottom and in the fourth and sixth columns from the right, among solar battery cells 100 shown in Fig. 56, are categorized into pattern mode "B".

As to defects corresponding to pattern mode "B", an apparatus that caused the defect can be estimated by determining a direction of solar battery cell 100. In order to determine a direction of solar battery cell 100, relation between a printing direction and a portion (direction) where finger electrode 108 is open should only be obtained. In order to obtain the relation, recognition unit 16 should only recognize shade of an electrode pattern. Naturally, it is CPU 500 that actually recognizes the shade.

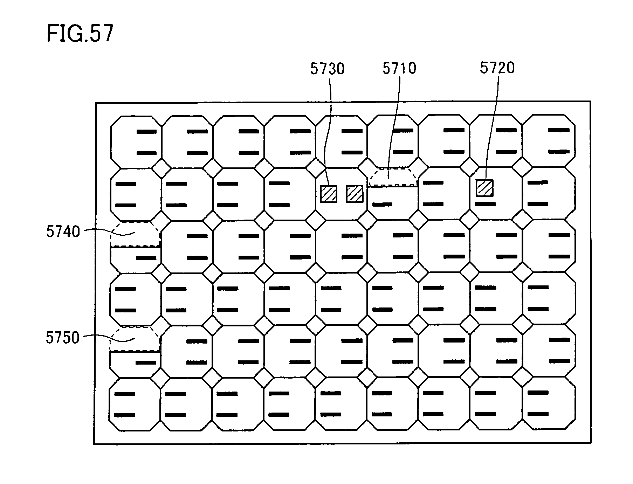

Fig. 57 illustrates a third exemplary image when a defect is caused. In the present embodiment, a defect 5710 in the second row from the top and in the fourth column from the right in solar battery cells 100 shown in Fig. 57 is categorized into pattern mode "A2". In the present embodiment, a defect 2020 and a defect 2030 in the second row from the top and in the second and fifth columns from the right respectively in solar battery cells 100 shown in Fig. 57 are categorized into pattern mode "B". In the present embodiment, a defect 2040 and a defect 2050 in the first column from the left and in the third and fifth rows from the top respectively in solar battery cells 100 shown in Fig. 57 are categorized into pattern mode "C".

Pattern mode "C" appears as an image of solar battery cell 100 at the end of solar battery string 110, in which the half plane of solar battery cell 100 connected to one bus bar electrode 104 is dark and the half plane thereof connected to another bus bar electrode 104 is bright. An image of solar battery cell 100 adjacent to solar battery cell 100 in which a defect corresponding to pattern mode "C" occurred is an image where brightness is even. This is because, in solar battery cell 100 in which a defect corresponding to pattern mode "C" occurred, an equally divided current path is formed by aluminum electrode 105 on the entire back surface.

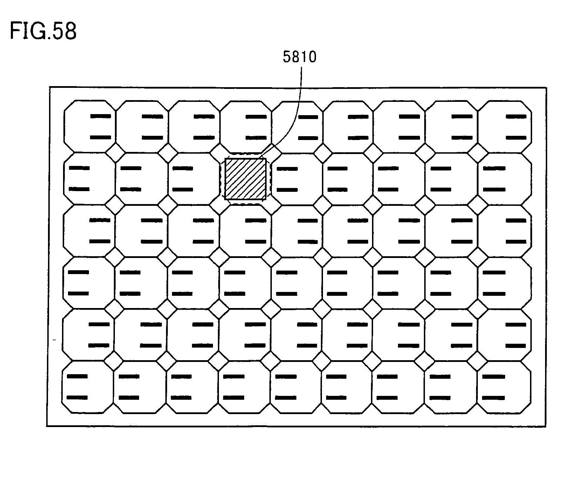

Fig. 58 illustrates a fourth exemplary image when a defect is caused. In the present embodiment, a defect in the second row from the top and in the fourth column from the right in solar battery cells 100 shown in Fig. 58 is categorized into pattern mode "A2". In the present embodiment, a defect 5810 in the second row from the top and in the fourth column from the left in solar battery cells 100 shown in Fig. 58 is categorized into pattern mode "D".

Pattern mode "D" appears as an image of solar battery cell 100 darker as a whole than adjacent solar battery cell 100. The cause of a defect corresponding to pattern mode "D" may be short-circuiting between a positive electrode and a negative electrode. The cause of short-circuiting between the positive electrode and the negative electrode may be wrap-around of a wafer edge by the solder in the step of forming solar battery string 110.

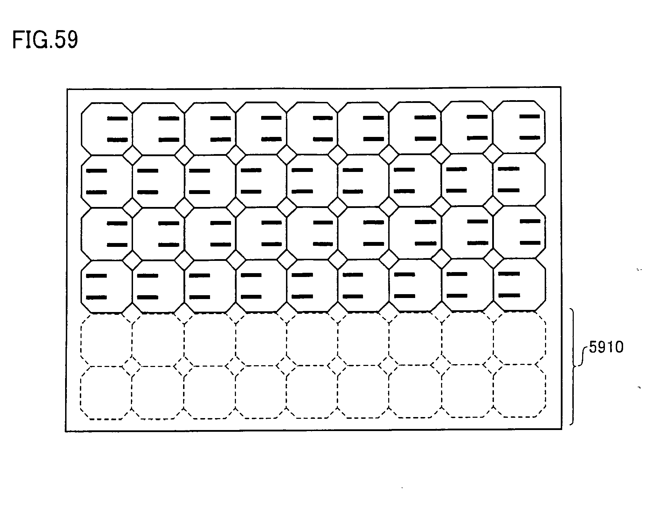

Fig. 59 illustrates a fifth exemplary image when a defect is caused. In the present embodiment, a defect 5910 in solar battery string 110 in two entire rows as shown in Fig. 59 is categorized into pattern mode "E".

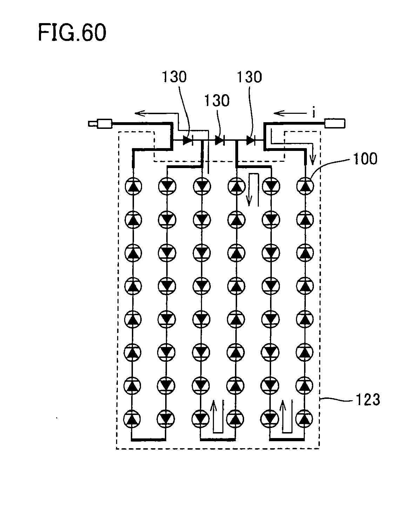

The cause of a defect corresponding to pattern mode "E" is generation of a current path via bypass diode 130 as shown in Fig. 60. Fig. 60 is a diagram showing as a circuit diagram, generation of a current path via bypass diode 130 in solar battery module in process 118. Here, the current does not flow through solar battery strings 110 in two columns on the left among solar battery strings 110 shown in Fig. 60. A cause of generation of the current path via bypass diode 130 may be such reverse connection in the following step where solar battery string 110 and the wiring member are soldered with the polarity being reversed in soldering. Namely, this step is the step of soldering wiring member 111, wiring member 112 and wiring member 113 to interconnectors 109 projecting from opposing ends of solar battery string 110 and interconnectors 109 projecting from opposing ends of another solar battery string 110. In addition, generation of the current path via bypass diode 130 may be caused by such a defect as short-circuiting of bypass diode 130 in the step of assembling the terminal box or the like.

As can clearly be seen from Figs. 55 to 59, shade of the electrode pattern of solar battery cell 100 is observed in the image obtained by solar battery module evaluation apparatus 3410. The shade of the electrode on the back surface of solar battery cell 100 is clearly seen. This is because such a phenomenon that light emission from silver electrode 107 on the back surface of solar battery cell 100 is less and such a phenomenon that interconnector 109 on the electrode on the light-receiving surface side of solar battery cell 100 blocks light emission of solar battery cell 100 are combined. In the present embodiment, an exemplary solar battery module, in which 54 solar battery cells are connected in series by alternately arranging in six columns, solar battery strings different in orientation each including 9 solar battery cells connected in series, has been described. If a manufacturing line dedicated for a string in an odd-numbered column and a manufacturing line dedicated for a string in an even-numbered column are employed, the manufacturing line can be specified by recognizing an image pattern including shade of these electrodes for each string.

As can clearly be understood from the description above, types of images picked up when solar battery cell 100 is defective are various. Even though the types of picked-up images may be various, what kind of defect is included in solar battery cell 100 can be specified based on these images, by performing a comparison operation through information processing or the like using a computer. In addition, if an image for each cell is to be recognized, adjacent solar battery cells can be compared with each other, and based on this comparison, a defective cell such as a cracked cell can also be detected.

In addition, adjacent solar battery cells can be compared with each other with their orientations being aligned by recognizing shade of the electrode pattern of solar battery cell 100, so that a defective cell can also accurately be detected.

In solar battery module in process 118, solar battery strings 110 different from each other in a direction of arrangement are alternately arranged. Thus, when solar battery strings 110 different from each other in the direction of arrangement are manufactured by two manufacturing lines, in which manufacturing line defective solar battery string 110 was fabricated can be determined by using the following method. Specifically, the method is a method of determining a direction of solar battery cell 100 by recognizing shade of the electrode pattern. By determining in which manufacturing line defective solar battery string 110 was fabricated, feedback to the manufacturing process can further effectively be provided.

In step S210, CPU 500 operating as evaluation unit 3519 determines whether solar battery module in process 118 is defective or not, that is, whether solar battery module in process 118 has passed the inspection or not, based on the result of comparison in step S208. If solar battery module in process 118 is determined as pass (YES in step S210), the process proceeds to step S212. Otherwise, (NO in step S210), the process proceeds to step S220.

In step S212, display 501 and interface 509 operating as evaluation unit 3519 output information indicating pass in the inspection under the control of CPU 500 similarly operating as evaluation unit 3519. The information indicating pass in the inspection is indicated, for example, by an indication that "this module has passed" or illumination of warning light 602 or the like.

In step S214, CPU 500 operating as evaluation unit 3519 causes RAM 505 operating as result storage unit 20 to store information indicating the result of pattern comparison obtained in step S208 together with the module ID number. In the present embodiment, the information actually stored as "information indicating the result of pattern comparison" is information indicating contents of a pattern mode or information indicating contents of a defective mode. Information indicating the contents of the pattern mode stored when the module has passed the inspection in step S210 or information indicating the contents of the defective mode is default information indicating that solar battery cell 100 is normal.

In step S216, display 501 and interface 509 operating as evaluation unit 3519 output information to an operator of solar battery module evaluation apparatus 3410 under the control of CPU 500 similarly operating as evaluation unit 3519. In the present embodiment, the information is output as display of character strings such as "replace the module" or illumination of warning light 602.

In step S218, display 501 and interface 509 operating as evaluation unit 3519 output information to an operator of solar battery module evaluation apparatus 3410 under the control of CPU 500 similarly operating as evaluation unit 3519. The output information is information indicating that solar battery module in process 118 is not conducting. In the present embodiment, the information is output as display of character strings such as "set again the module" or illumination of warning light 602.

In step S220, display 501 and interface 509 operating as evaluation unit 3519 output information indicating failure in the inspection under the control of CPU 500 similarly operating as evaluation unit 3519. In the present embodiment, the information is output as display of character strings such as "this module failed the inspection" or illumination of warning light 602.

In step S222, CPU 500 operating as evaluation unit 3519 causes RAM 505 operating as result storage unit 20 to store information on pass or fail in the inspection (a defective portion in solar battery module in process 118, a pattern mode, and the like) together with the module ID number.

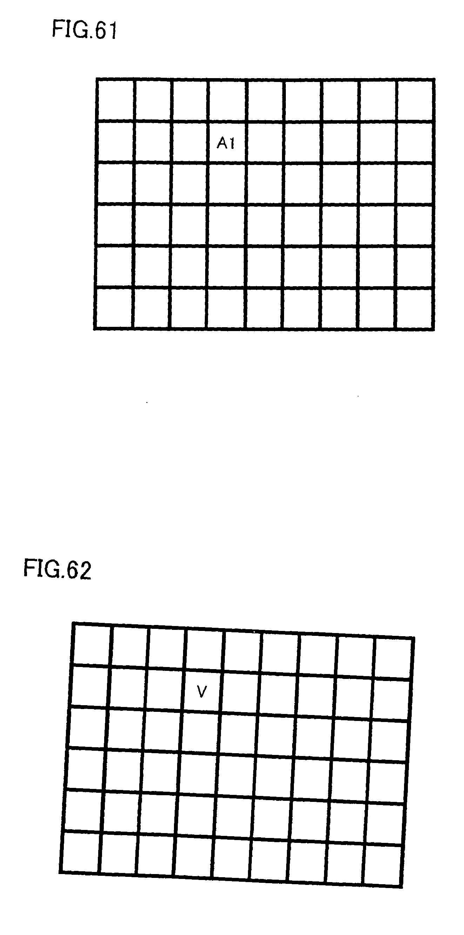

In step S224, CPU 500 operating as evaluation unit 3519 specifies the step that resulted in a defect by analyzing information such as a pattern mode obtained in step S208 or pattern modes accumulated in result storage unit 20. Figs. 61 to 70 show processing performed by CPU 500 that operates as evaluation unit 3519 on the images obtained by solar battery module evaluation apparatus 3410 according to the present embodiment.

Fig. 61 is a diagram illustrating a state that the image shown in Fig. 55 has been subjected to processing for division into solar battery cells 100. Fig. 61 shows that solar battery cell 100 in the second row from the top and in the fourth column from the left among solar battery cells 100 constituting solar battery module in process 118 corresponds to pattern mode "A1". Fig. 62 shows that solar battery cell 100 corresponding to pattern mode "A1" corresponds to defective mode "V", that is, cell crack in a high resistance state, because solar battery cell 100 adjacent to solar battery cell 100 corresponding to pattern mode "A1" corresponds to no pattern mode. The high resistance state refers to such a state that a current is less likely to flow. If a crack is generated in a cell in a string of the solar battery module in which a plurality of solar battery cells are connected to one another through interconnectors, a pattern showing such an image is observed.

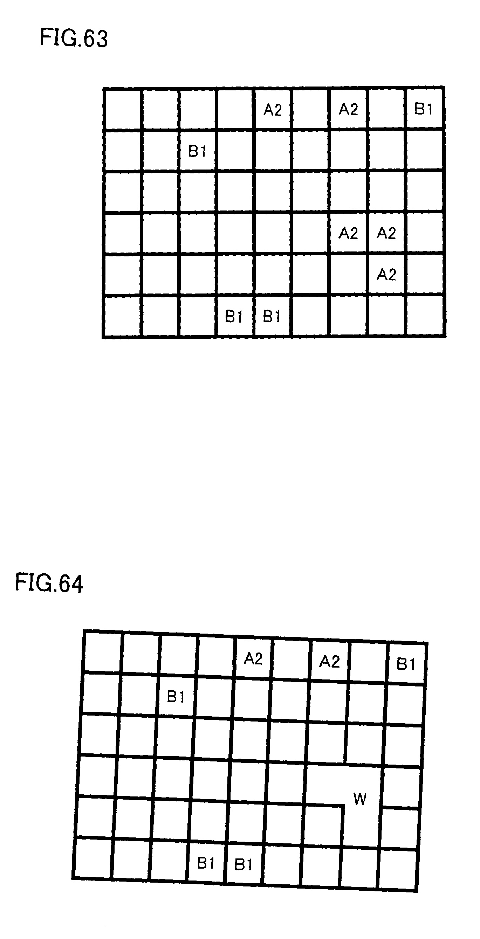

Figs. 63 and 64 are diagrams illustrating a state that the image shown in Fig. 56 has been subjected to processing similar to that described with reference to Figs. 61 and 62. Fig. 63 shows that solar battery cells 100 in the fourth row from the top and in the second and third columns from the right among solar battery cells 100 constituting solar battery module in process 118 correspond to pattern mode "A2". Fig. 64 shows that solar battery cells 100 corresponding to pattern mode "A2" correspond to defective mode "W", that is, continuous cell crack, because adjacent solar battery cells 100 correspond to the same pattern mode "A2", which means cluster formation.

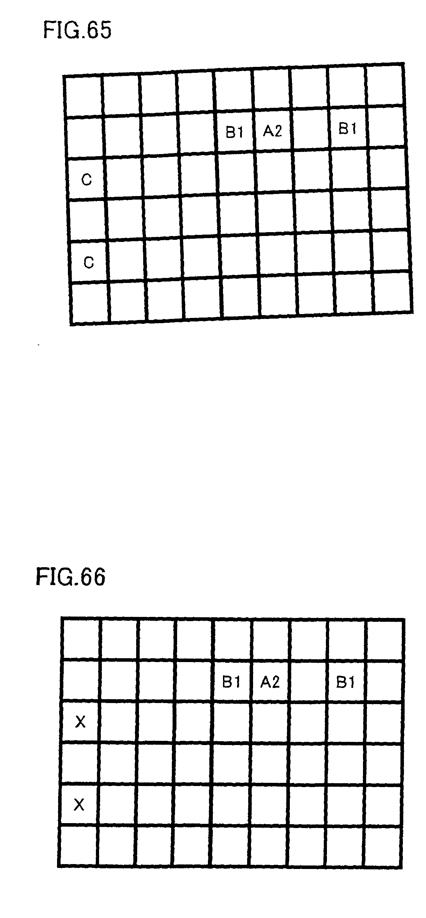

Figs. 65 and 66 are diagrams illustrating a state that the image shown in Fig. 57 has been subjected to processing similar to that described with reference to Figs. 61 and 62. Fig. 65 shows that solar battery cells 100 in the first column from the left and in the third and fifth rows from the top among solar battery cells 100 constituting solar battery module in process 118 correspond to pattern mode "C". Fig. 66 shows that solar battery cell 100 corresponding to pattern mode "C" corresponds to defective mode "X", that is, poor connection between solar battery string 110 and the wiring member, because solar battery cell 100 adjacent to solar battery cell 100 corresponding to pattern mode "C" corresponds to no pattern mode.

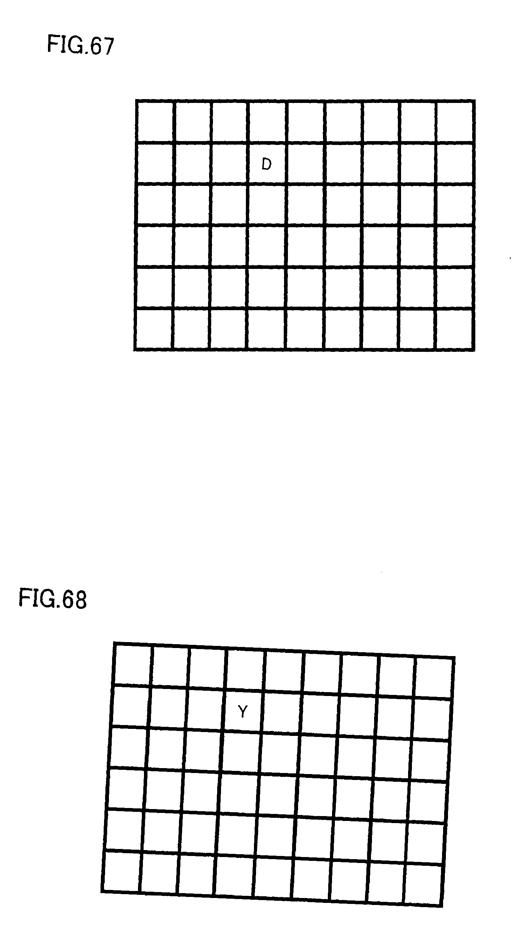

Figs. 67 and 68 are diagrams illustrating a state that the image shown in Fig. 58 has been subjected to processing similar to that described with reference to Figs. 61 and 62. Fig. 67 shows that solar battery cell 100 in the fourth column from the left and in the second row from the top among solar battery cells 100 constituting solar battery module in process 118 corresponds to pattern mode "D". Fig. 68 shows that solar battery cell 100 corresponding to pattern mode "D" corresponds to defective mode "Y", that is, short-circuiting (poor insulation) between the positive electrode and the negative electrode of solar battery cell 100, because solar battery cell 100 adjacent to solar battery cell 100 corresponding to pattern mode "D" corresponds to no pattern mode.

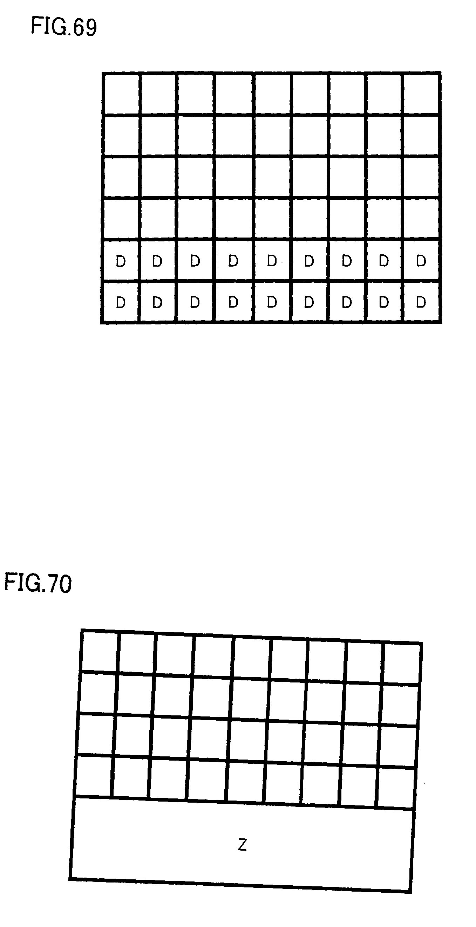

Figs. 69 and 70 are diagrams illustrating a state that the image shown in Fig. 59 has been subjected to processing similar to that described with reference to Figs. 61 and 62. Fig. 69 shows that solar battery cells 100 in the two rows at the bottom among solar battery cells 100 constituting solar battery module in process 118 correspond to pattern mode "D". Fig. 70 shows that solar battery cells 100 corresponding to pattern mode "D" correspond to defective mode "Z", that is, reverse connection of solar battery string 110 or short-circuiting of bypass diode 130, because the same pattern mode is observed for each string, which means cluster formation. It is thus very effective in data analysis or in managing change of state over time to accumulate pattern mode information as history information.

In step S226, communication device 508 operating as evaluation unit 3519 transfers feedback data to an apparatus performing the step that resulted in a defect under the control of CPU 500 similarly operating as evaluation unit 3519. In the present embodiment, the "feedback data" refers to data of the defective mode. Instead of transferring the feedback data, display 501 and interface 509 operating as evaluation unit 3519 may output feedback data to an operator or a manager performing the step that resulted in a defect. After these processes, contents in at least one step among the steps from step S 100 to step S4022 described above are changed in accordance with contents in the result of evaluation by evaluation unit 3519, that is, the feedback data. Change in the contents in the step may be made automatically by an apparatus responsible for each step from step S 100 to step S4022 described above or manually by the manager of these apparatuses.

As described above, the solar battery module evaluation apparatus according to the second embodiment of the present invention includes a supply apparatus, an image pick-up apparatus, and an output apparatus. The supply apparatus supplies energy. The output apparatus outputs information indicating whether a solar battery module is defective or not, based on data of a first image picked up by the image pick-up apparatus, the image being an optical image that appears as a result of supply of energy to the solar battery module.

In addition, the output apparatus described above includes a first storage circuit, a comparison circuit, and a circuit for output. The first storage circuit stores data of a second image which is an optical image that appears as a result of supply of energy to a defective solar battery module, in association with information on a defect represented by the second image. The comparison circuit compares the first image with the second image. The circuit for output outputs information on the defect represented by the first image when it is determined that the first image and the second image exhibit a defective pattern of the same type.

In addition, the supply apparatus described above includes an apparatus for supplying energy to a solar battery module of a flat panel type made of silicon.

In addition, the supply apparatus described above includes an apparatus for supplying electric power.

In addition, the apparatus for supplying electric power described above includes an apparatus for supplying electric power for having a solar battery cell constituting the solar battery module emit light through electroluminescence phenomenon.

In addition, the output apparatus described above includes a circuit for outputting information on whether the solar battery module is defective or not, based on data of the first image for one solar battery cell.

In addition, the solar battery module evaluation apparatus described above further includes a first identification circuit and a second storage circuit. The first identification circuit identifies a first identification code which is an identification code for data of the first image. The second storage circuit stores the data of the first image and the first identification code in association with each other.

In addition, the solar battery module evaluation apparatus described above further includes a second identification circuit and a third storage circuit. The second identification circuit identifies a second identification code which is an identification code of the solar battery module. The third storage circuit stores information indicating whether the solar battery module is defective or not and the second identification code in association with each other.

In addition, the solar battery module evaluation method according to the present embodiment includes a supply step, an image pick-up step, and an output step. In the supply step, energy is supplied to the solar battery module. In the image pick-up step, the image of the solar battery module is picked up. In the output step, pattern information indicating whether the solar battery module is defective or not is output, based on the data of the first image picked up in the image pick-up step, the image being an optical image that appears as a result of supply of energy to the solar battery module.

In addition, the solar battery module manufacturing method according to the present embodiment includes a first fabrication step, a second fabrication step, an enclosing step, a supply step, an image pick-up step, a determination step, and a changing step. In the first fabrication step, the solar battery string is fabricated by connecting the solar battery cells in series through a conductive member. In the second fabrication step, the solar battery cell array is fabricated by connecting a plurality of solar battery strings in series through a conductive member. In the enclosing step, the solar battery cell array is enclosed with the enclosing material. In the supply step, energy is supplied to the solar battery module which is the solar battery cell array enclosed in the enclosing step. In the image pick-up step, the image of the solar battery module is picked up. In the determination step, whether the solar battery module is defective or not is determined based on the data of the first image picked up in the image pick-up step, the image being an optical image that appears as a result of supply of energy to the solar battery module. In the changing step, contents in at least one step among the first fabrication step, the second fabrication step, and the enclosing step are changed in accordance with the result of determination in the determination step.

Thus, the solar battery module evaluation apparatus and the solar battery module evaluation method according to the present embodiment can quickly specify well a defect caused in the process of manufacturing the solar battery module and a cause thereof by analyzing an optical image picked up by the camera. This is because the optical image that appears as a result of supply of energy to the solar battery module well reflects the defect caused in the process of manufacturing the solar battery module and the cause thereof.

When the defect caused in the process of manufacturing the solar battery module and the cause thereof are quickly specified, the solar battery module evaluation apparatus and the solar battery module evaluation method according to the present embodiment can transfer the feedback data to the apparatus that has caused the defect or notify the operator or the manager of the apparatus of that fact. Management of the process of manufacturing the solar battery module connected through the interconnectors can thus be facilitated. In addition, feedback control of manufacturing of the solar battery module can be carried out.

As feedback control can be carried out, the solar battery module capable of maintaining high electric power generation efficiency can efficiently be manufactured. As such, solar battery modules capable of maintaining high electric power generation efficiency can be mass-produced in a stable manner. In addition, by constructing a solar power generation system with such solar battery modules, a solar power generation system capable of maintaining high electric power generation efficiency can be produced at low cost. As such solar power generation systems are produced at low cost, initial investment in the solar power generation system or maintenance cost can soon be recovered. Early recovery of initial investment or maintenance cost accelerates further widespread use of the solar power generation system. Consequently, a solar battery module evaluation apparatus, a solar battery module evaluation method, and a solar battery module manufacturing method capable of accelerating further widespread use of the solar power generation system can be provided.

In addition, the output apparatus of the solar battery module evaluation apparatus according to the present embodiment includes a circuit for outputting information indicating whether the solar battery module is defective or not based on data of the first image including shadow of an electrode of the solar battery cell.

In addition, the circuit for output described above includes a circuit for outputting information on whether the solar battery module is defective or not, using data of a portion on which shadow of the electrode is cast in the data of the first image. Thus, as a direction of a solar battery cell can be determined by recognizing shade of the electrode pattern, a defective solar battery cell can be specified based on accurate coordinate information.

The solar battery module evaluation apparatus according to a first variation of the present embodiment may be an apparatus evaluating a solar battery module including solar battery cells formed from a single crystal or amorphous silicon flat plate.

Alternatively, a solar battery module evaluation apparatus according to a second variation of the present embodiment may include an apparatus supplying energy to solar battery module in process 118 instead of power supply unit 11 described above. This solar battery module evaluation apparatus may include an apparatus supplying energy to solar battery module in process 118 in addition to power supply unit 11 described above. Examples of the form of energy to be supplied include light. Camera 12 can thus pick up an optical image that appears from solar battery cell 100 through photoluminescence phenomenon.

Alternatively, a solar battery module evaluation apparatus according to a third variation of the present embodiment may include an apparatus supplying electric power other than electric power for light emission through electroluminescence phenomenon, instead of power supply unit 11 described above.

Alternatively, a solar battery module evaluation apparatus according to a fourth variation of the present embodiment may include an operation unit instead of pattern storage unit 17 and comparison unit 18. Here, the operation unit performs an operation on data of a portion of which pattern has been recognized by recognition unit 16, in the image picked up by camera 12. Such an operation includes processing for calculating an average value of lightness of a pixel constituting the portion of which pattern has been recognized by recognition unit 16 or processing for calculating standard deviation of such lightness.

Here, the solar battery module evaluation apparatus includes, instead of evaluation unit 3519, an apparatus outputting information corresponding to a result of operation by the operation unit, out of pattern information indicating whether solar battery module in process 118 is defective or not. The information output by this apparatus includes information indicating whether the average value of lightness is equal to or greater than a threshold value and information indicating whether standard deviation of lightness is equal to or greater than a threshold value. The processing unit of the solar battery module evaluation apparatus serves here again as an apparatus outputting pattern information indicating whether solar battery module in process 118 is defective or not, based on data of the image picked up by camera 12, the image being an optical image that appears as a result of supply of electric power to solar battery module in process 118.

Alternatively, a recognition unit in a solar battery module evaluation apparatus according to a fifth variation of the present embodiment may recognize solar battery string 110 instead of solar battery cell 100 in step S206. Thus, a processing unit of the solar battery module evaluation apparatus according to the fifth variation of the present embodiment operates as an apparatus outputting pattern information indicating whether solar battery module in process 118 is defective or not, based on data of the first image for one solar battery string.

Alternatively, a processing unit in a solar battery module evaluation apparatus according to a sixth variation of the present embodiment may not include result storage unit 20. Here, pattern information indicating whether solar battery module in process 118 is defective or not and data necessary for notifying as feedback the manufacturing apparatus of defect are presented to an operator on display 501 or through warning light 602.

Alternatively, in a seventh variation of the present embodiment, processing in at least one step among steps from step S 100 to step S4024 except for step S4014 may manually be performed by an operator. In addition, the processing in step S4014 may be performed by the manufacturing apparatus.

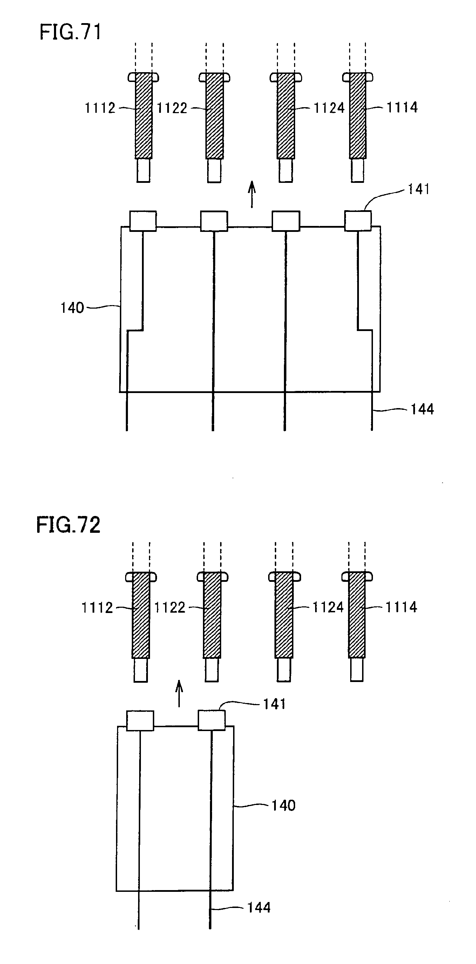

In addition, in an eighth variation of the present embodiment, as shown in Fig. 71, the connector may include a plurality of terminals 141 in contact with lead 1112, lead 1122, lead 1124, and lead 1114, respectively. Here, the main body of power supply unit 11 sets a voltage across at least two terminals 141 among the plurality of terminals 141 to a voltage adapted to combination of terminals 141. For example, in this variation, the main body of power supply unit 11 sets a voltage across lead 1112 and lead 1122 to the following voltage. Namely, the voltage is such that all solar battery strings 110, through which a current flows as a result of supply of electric power from these leads, emit light through electroluminescence phenomenon.

The main body of power supply unit 11 also sets a voltage across lead 1122 and lead 1124 and a voltage across lead 1124 and lead 1114 to a similar voltage. Here, inspection of lead 1112 and lead 1122, inspection of lead 1122 and lead 1124, and inspection of lead 1124 and lead 1114 should individually be conducted. When this connector is employed, electroluminescence phenomenon takes place only in solar battery string 110 supplied with electric power. Therefore, inspection is conducted for each solar battery string 110.

In addition, in a ninth variation of the present embodiment, as shown in Fig. 72, the connector may include two terminals 141. Here, inspection of lead 1112 and lead 1122, inspection of lead 1122 and lead 1124, and inspection of lead 1124 and lead 1114 should individually be conducted. In inspection, two terminals 141 included in connector 140 are connected to the wiring member to be inspected. Here, bypass diode 150 is not necessary. When this connector is employed as well, electroluminescence phenomenon takes place only in solar battery string 110 supplied with electric power. Therefore, inspection is conducted for each solar battery string 110.

A plurality of diodes 150 connected between a plurality of terminals may not be connected in series, and polarity of some diodes may be changed as appropriate, depending on setting of a voltage used for inspection.

It should be understood that the embodiments disclosed herein are illustrative and non-restrictive in every respect. The scope of the present invention is defined by the terms of the claims, rather than the description above, and is intended to include any modifications within the scope and meaning equivalent to the terms of the claims.

## Claims

1. An evaluation apparatus (10) for evaluating a solar battery module, said solar battery module including a plurality of solar battery cells, said plurality of solar battery cells being connected to one another through an interconnector, said evaluation apparatus comprising:
a supply unit (11) supplying energy to said solar battery module;
an image pick-up unit (12) outputting image data by picking up an optical image that appears as a result of supply of said energy; and
an output unit (13) for outputting pattern information indicating whether said solar battery module is defective, based on data of a first image corresponding to said optical image.

2. The evaluation apparatus for evaluating a solar battery module according to claim 1, wherein
said output unit includes
a first storage unit (17) storing in advance data of a second image which is an optical image that appears as a result of supply of said energy to a defective solar battery module,
a comparison unit (18) comparing said first image with said second image, and
an information output unit (19) outputting information on defect presented by said first image when it is determined that said first image and said second image exhibit a defective pattern of an identical type.

3. The evaluation apparatus for evaluating a solar battery module according to claim 1, wherein
said output unit outputs said pattern information based on said data of said first image for one solar battery string.

4. The evaluation apparatus for evaluating a solar battery module according to claim 1, wherein
said output unit outputs said pattern information based on said data of said first image for one solar battery cell.

5. The evaluation apparatus for evaluating a solar battery module according to claim 1, wherein
said output unit outputs said pattern information based on said data of said first image including shadow of an electrode of the solar battery cell.

6. The evaluation apparatus for evaluating a solar battery module according to claim 5, wherein
said output unit outputs said pattern information by using data of a portion on which shadow of said electrode is cast in said data of said first image.

7. The evaluation apparatus for evaluating a solar battery module according to claim 1, further comprising:
a first identification unit identifying a first identification code which is an identification code for said data of said first image; and
a second storage unit storing said data of said first image and said first identification code in association with each other.

8. The evaluation apparatus for evaluating a solar battery module according to claim 7, further comprising:
a second identification unit identifying a second identification code which is an identification code of said solar battery module; and
a third storage unit for storing said pattern information and said second identification code in association with each other.

9. The evaluation apparatus for evaluating a solar battery module according to claim 1, wherein
said supply unit supplies energy to said solar battery module of a flat panel type made of silicon.

10. The evaluation apparatus for evaluating a solar battery module according to claim 1, wherein
said supply unit supplies electric power.

11. The evaluation apparatus for evaluating a solar battery module according to claim 10, wherein
said supply unit supplies said electric power for having each said solar battery cell constituting said solar battery module emit light through electroluminescence phenomenon.

12. The evaluation apparatus for evaluating a solar battery module according to claim 1, wherein
said supply unit supplies energy to said solar battery cell through a lead connected to said interconnector.

13. The evaluation apparatus for evaluating a solar battery module according to claim 1, wherein
said supply unit supplies said energy through a plurality of the leads to a solar battery string obtained by connecting said solar battery cells to one another in series through said interconnector.

14. The evaluation apparatus for evaluating a solar battery module according to claim 1, wherein
said supply unit includes
a plurality of terminals in contact with a plurality of the leads respectively, for supplying said energy, and
a plurality of diodes connected between said plurality of terminals, respectively.

15. The evaluation apparatus for evaluating a solar battery module according to claim 1, wherein
said supply unit includes
a plurality of terminals in contact with a plurality of the leads respectively, and
a setting unit (140) for setting a voltage across at least two said terminals among said plurality of terminals to a voltage adapted to combination of said terminals.

16. The evaluation apparatus for evaluating a solar battery module according to claim 15, wherein
said setting unit includes a plurality of diodes (150) connected between said plurality of terminals respectively and sets a voltage across opposing ends of said plurality of diodes.

17. A method of evaluating a solar battery module, said solar battery module including a plurality of solar battery cells, said plurality of solar battery cells being connected to one another through an interconnector, said method comprising the steps of:
supplying energy to said solar battery module;
outputting image data by picking up an optical image that appears as a result of supply of said energy; and
outputting pattern information indicating whether said solar battery module is defective, based on data of a first image corresponding to said optical image.

18. The method of evaluating a solar battery module according to claim 17, wherein
said step of supplying energy includes the step of supplying energy to said solar battery cell through a lead drawn from an enclosing material and connected to said interconnector, after said plurality of solar battery cells are laminated with said enclosing material and before said solar battery module is cured.

19. The method of evaluating a solar battery module according to claim 18, wherein
said step of supplying energy to said solar battery cell includes the step of supplying said energy through said lead to each of a plurality of sets of said solar battery cells, in which said solar battery cells are connected to one another in series through said interconnector and sectioned by said lead.

20. A method of manufacturing a solar battery module, comprising:
a first fabrication step of fabricating a solar battery string by connecting solar battery cells to one another in series through a conductive member;
a second fabrication step of fabricating a solar battery cell array by connecting a plurality of said solar battery strings to one another in series through a conductive member;
an enclosing step of enclosing said solar battery cell array with an enclosing material;
a supply step of supplying energy to a solar battery module which is the solar battery cell array enclosed in said enclosing step;
an image pick-up step of picking up an image of said solar battery module;
a determination step of determining whether said solar battery module is defective based on data of a first image which is an image picked up in said image pick-up step, the image being an optical image that appears as a result of supply of said energy to the solar battery module; and
a changing step of changing content in at least one step among said first fabrication step, said second fabrication step and said enclosing step, in accordance with a result of determination in said determination step.

21. A method of manufacturing a solar battery module, comprising:
a first fabrication step of fabricating a solar battery string by connecting solar battery cells to one another in series through a conductive member;
a second fabrication step of fabricating a solar battery cell array by connecting a plurality of said solar battery strings to one another in series through a conductive member;
a laminating step of laminating said solar battery cell array with an enclosing material;
a supply step of supplying energy to said solar battery cell through a lead drawn from said enclosing material and connected to the interconnector;
an image pick-up step of picking up an image of said solar battery module;
a determination step of determining whether said solar battery module is defective based on data of a first image which is an image picked up in said image pick-up step, the image being an optical image that appears as a result of supply of said energy to said solar battery module;
a curing step of curing said solar battery module when said solar battery module has been determined as non-defective in said determination step; and
a connection step of connecting an electric power output terminal to said lead.

22. The method of manufacturing a solar battery module according to claim 21, further comprising a replacement step of replacing said solar battery cell when said solar battery module has been determined as defective in said determination step.

23. The method of manufacturing a solar battery module according to claim 21, further comprising a replacement step of replacing a part of said solar battery module on a basis of said solar battery string when said solar battery module has been determined as defective in said determination step.

24. The method of manufacturing a solar battery module according to claim 21, wherein
said laminating step includes the step of laminating said enclosing material with at least a sheet material and laminating said solar battery cell array, and
said method of manufacturing a solar battery module further comprises a replacement step of replacing at least one of said solar battery cell and said solar battery string after at least a part of said sheet material is peeled off, when said solar battery module has been determined as defective in said determination step.

25. The method of manufacturing a solar battery module according to claim 21, wherein
said enclosing material is ethylene vinyl acetate.

## Amended claims

### Amended claims under Art. 19.1 PCT

1. (Amended) An evaluation apparatus (10) for evaluating a solar battery module, said solar battery module including a plurality of solar battery cells, said plurality of solar battery cells being connected to one another through an interconnector, said evaluation apparatus comprising:
a supply unit (11) supplying energy to said solar battery module;
an image pick-up unit (12) outputting image data by picking up an optical image that appears as a result of supply of said energy; and
an output unit (13) for performing pattern recognition based on a shape of each said solar battery cell, based on data of a first image corresponding to said optical image, identifying a defective pattern mode for each pattern, and outputting pattern information representing sequence of pattern modes indicating whether said solar battery module is defective.

2. The evaluation apparatus for evaluating a solar battery module according to claim 1, wherein
said output unit includes
a first storage unit (17) storing in advance data of a second image which is an optical image that appears as a result of supply of said energy to a defective solar battery module,
a comparison unit (18) comparing said first image with said second image, and
an information output unit (19) outputting information on defect presented by said first image when it is determined that said first image and said second image exhibit a defective pattern of an identical type.

3. The evaluation apparatus for evaluating a solar battery module according to claim 1, wherein
said output unit outputs said pattern information based on said data of said first image for one solar battery string.

4. The evaluation apparatus for evaluating a solar battery module according to claim 1, wherein
said output unit outputs said pattern information based on said data of said first image for one solar battery cell.

5. The evaluation apparatus for evaluating a solar battery module according to claim 1, wherein
said output unit outputs said pattern information based on said data of said first image including shadow of an electrode of the solar battery cell.

6. The evaluation apparatus for evaluating a solar battery module according to claim 5, wherein
said output unit outputs said pattern information by using data of a portion on which shadow of said electrode is cast in said data of said first image.

7. The evaluation apparatus for evaluating a solar battery module according to claim 1, further comprising:
a first identification unit identifying a first identification code which is an identification code for said data of said first image; and
a second storage unit storing said data of said first image and said first identification code in association with each other.

8. The evaluation apparatus for evaluating a solar battery module according to claim 7, further comprising:
a second identification unit identifying a second identification code which is an identification code of said solar battery module; and
a third storage unit for storing said pattern information and said second identification code in association with each other.

9. The evaluation apparatus for evaluating a solar battery module according to claim 1, wherein
said supply unit supplies energy to said solar battery module of a flat panel type made of silicon.

10. The evaluation apparatus for evaluating a solar battery module according to claim 1, wherein
said supply unit supplies electric power.

11. The evaluation apparatus for evaluating a solar battery module according to claim 10, wherein
said supply unit supplies said electric power for having each said solar battery cell constituting said solar battery module emit light through electroluminescence phenomenon.

12. The evaluation apparatus for evaluating a solar battery module according to claim 1, wherein
said supply unit supplies energy to said solar battery cell through a lead connected to said interconnector.

13. The evaluation apparatus for evaluating a solar battery module according to claim 1, wherein
said supply unit supplies said energy through a plurality of the leads to a solar battery string obtained by connecting said solar battery cells to one another in series through said interconnector.

14. The evaluation apparatus for evaluating a solar battery module according to claim 1, wherein
said supply unit includes
a plurality of terminals in contact with a plurality of the leads respectively, for supplying said energy, and
a plurality of diodes connected between said plurality of terminals, respectively.

15. The evaluation apparatus for evaluating a solar battery module according to claim 1, wherein
said supply unit includes
a plurality of terminals in contact with a plurality of the leads respectively, and
a setting unit (140) for setting a voltage across at least two said terminals among said plurality of terminals to a voltage adapted to combination of said terminals.

16. The evaluation apparatus for evaluating a solar battery module according to claim 15, wherein
said setting unit includes a plurality of diodes (150) connected between said plurality of terminals respectively and sets a voltage across opposing ends of said plurality of diodes.

17. (Amended) A method of evaluating a solar battery module, said solar battery module including a plurality of solar battery cells, said plurality of solar battery cells being connected to one another through an interconnector, said method comprising the steps of:
supplying energy to said solar battery module;
outputting image data by picking up an optical image that appears as a result of supply of said energy;
performing pattern recognition based on a shape of each said solar battery cell, based on data of a first image corresponding to said optical image;
identifying a defective pattern mode for each pattern; and
outputting pattern information representing sequence of pattern modes indicating whether said solar battery module is defective,.

18. The method of evaluating a solar battery module according to claim 17, wherein
said step of supplying energy includes the step of supplying energy to said solar battery cell through a lead drawn from an enclosing material and connected to said interconnector, after said plurality of solar battery cells are laminated with said enclosing material and before said solar battery module is cured.

19. The method of evaluating a solar battery module according to claim 18, wherein
said step of supplying energy to said solar battery cell includes the step of supplying said energy through said lead to each of a plurality of sets of said solar battery cells, in which said solar battery cells are connected to one another in series through said interconnector and sectioned by said lead.

20. A method of manufacturing a solar battery module, comprising:
a first fabrication step of fabricating a solar battery string by connecting solar battery cells to one another in series through a conductive member;
a second fabrication step of fabricating a solar battery cell array by connecting a plurality of said solar battery strings to one another in series through a conductive member;
an enclosing step of enclosing said solar battery cell array with an enclosing material;
a supply step of supplying energy to a solar battery module which is the solar battery cell array enclosed in said enclosing step;
an image pick-up step of picking up an image of said solar battery module;
a determination step of determining whether said solar battery module is defective based on data of a first image which is an image picked up in said image pick-up step, the image being an optical image that appears as a result of supply of said energy to the solar battery module; and
a changing step of changing content in at least one step among said first fabrication step, said second fabrication step and said enclosing step, in accordance with a result of determination in said determination step.

21. A method of manufacturing a solar battery module, comprising:
a first fabrication step of fabricating a solar battery string by connecting solar battery cells to one another in series through a conductive member;
a second fabrication step of fabricating a solar battery cell array by connecting a plurality of said solar battery strings to one another in series through a conductive member;
a laminating step of laminating said solar battery cell array with an enclosing material;
a supply step of supplying energy to said solar battery cell through a lead drawn from said enclosing material and connected to the interconnector;
an image pick-up step of picking up an image of said solar battery module;
a determination step of determining whether said solar battery module is defective based on data of a first image which is an image picked up in said image pick-up step, the image being an optical image that appears as a result of supply of said energy to said solar battery module;
a curing step of curing said solar battery module when said solar battery module has been determined as non-defective in said determination step; and
a connection step of connecting an electric power output terminal to said lead.

22. The method of manufacturing a solar battery module according to claim 21, further comprising a replacement step of replacing said solar battery cell when said solar battery module has been determined as defective in said determination step.

23. The method of manufacturing a solar battery module according to claim 21, further comprising a replacement step of replacing a part of said solar battery module on a basis of said solar battery string when said solar battery module has been determined as defective in said determination step.

24. The method of manufacturing a solar battery module according to claim 21, wherein
said laminating step includes the step of laminating said enclosing material with at least a sheet material and laminating said solar battery cell array, and
said method of manufacturing a solar battery module further comprises a replacement step of replacing at least one of said solar battery cell and said solar battery string after at least a part of said sheet material is peeled off, when said solar battery module has been determined as defective in said determination step.

25. The method of manufacturing a solar battery module according to claim 21, wherein
said enclosing material is ethylene vinyl acetate.
